(19) Europäisches Patentamt
European Patent Office
Office européen des brevets

(11) EP 1 116 425 B1

(12) EUROPÄISCHE PATENTSCHRIFT

(45) Veröffentlichungstag und Bekanntmachung des Hinweises auf die Patenterteilung:
**03.11.2004 Patentblatt 2004/45**

(21) Anmeldenummer: **99952388.9**

(22) Anmeldetag: **13.08.1999**

(51) Int Cl.^7: **H05K 13/00**

(86) Internationale Anmeldenummer:
**PCT/DE1999/002536**

(87) Internationale Veröffentlichungsnummer:
**WO 2000/011923 (02.03.2000 Gazette 2000/09)**

(54) **VERFAHREN UND VORRICHTUNG ZUR RECHNERGESTÜTZTEN PIPETTENAUSWAHL FÜR EINEN BESTÜCKUNGSKOPF UND ZUR ZUORDNUNG VON BAUELEMENTEN ZU DEN IN EINER PIPETTENAUSWAHL VORGEGEBENEN PIPETTENARTEN**

METHOD AND DEVICE FOR COMPUTER ASSISTED SELECTION OF PIPETTES FOR THE AUTOMATIC PLACEMENT HEAD OF AN AUTOMATIC PLACEMENT MACHINE AND FOR ALLOCATING COMPONENTS TO PREDETERMINED TYPES OF PIPETTES IN A SELECTION OF PIPETTES

PROCEDE ET DISPOSITIF POUR LA SELECTION, ASSISTEE PAR ORDINATEUR, DE PIPETTES DESTINEES A UNE TETE DE MISE EN PLACE DE COMPOSANTS ET POUR L'AFFECTATION DE COMPOSANTS AUX TYPES DE PIPETTES PREDETERMINEES LORS D'UNE SELECTION

(84) Benannte Vertragsstaaten:
**CH DE FR GB IT LI NL**

(30) Priorität: **25.08.1998 DE 19838595**

(43) Veröffentlichungstag der Anmeldung:
**18.07.2001 Patentblatt 2001/29**

(73) Patentinhaber: **Siemens Aktiengesellschaft**
**80333 München (DE)**

(72) Erfinder:
- **BAUER, Petra**
  **D-80797 München (DE)**
- **ENDERS, Reinhard**
  **D-80999 München (DE)**

(74) Vertreter: **Berg, Peter, Dipl.-Ing.**
**Siemens AG**
**Postfach 22 16 34**
**80506 München (DE)**

(56) Entgegenhaltungen:
**EP-A- 0 036 826**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft eine rechnergestützte Pipettenauswahl für einen Bestückungskopf eines Bestückungsautomaten und die Zuordnung von Bauelementen zu den in einer Pipettenauswahl vorgegebenen Pipettenarten.

Von einem Bestückungsautomaten werden Bauelemente, z.B. elektrische Widerständen, Transistoren, Kondensatoren, etc., auf eine Leiterplatte auf vorgegebene Positionen innerhalb der Leiterplatte gesetzt. Dies geschieht dadurch, daß unter Verwendung eines Bestückungskopfes die Bauelemente von einem Bauelementespeicher zu der jeweiligen Position über der Leiterplatte transportiert und anschließend gesetzt werden.

Es werden üblicherweise verschiedene Arten von Bestückköpfen eingesetzt. Ein solcher Bestückungskopf ist z.B. der sogenannte SP-Kopf (Speed Placer-Kopf), mit dem mehrere Bauelemente aus dem Bauelementespeicher aufgenommen, transportiert und sukzessive auf die Leiterplatte gesetzt werden können.

Ein SP-Bestückungskopf weist mehrere Segmente (üblicherweise 6 oder 12 Segmente) auf, auf welchen jeweils eine Pipette aufgebracht werden kann. Mit den Pipetten können Bauelemente aufgenommen und gesetzt werden. Es gibt verschiedene Pipettenarten, mit denen jeweils unterschiedliche Arten von Bauelementen gesetzt werden können. Die Bestückung einer Leiterplatte mit Bauelementen durch einen SP-Bestückungskopf erfolgt üblicherweise in mehreren Iterationen (Zyklen), in denen jeweils der Bestückungskopf zunächst maximal die Anzahl der Bauelemente aufnimmt, die er verarbeiten kann und sie anschließend in derselben Reihenfolge, in der er sie aufgenommen hat, auf der Leiterplatte absetzt. Die Zeit, die für einen Zylklus benötigt wird, hängt nur in geringem Maße von der Zahl der in diesen Zyklus aufgenommenen und gesetzten Bauelemente ab, so daß eine möglichst geringe Zahl von Zyklen für die Bestückung das zeitkritischste Kriterium im Rahmen der Bestückung darstellt.

Es ist somit wünschenswert, daß in den einzelnen Zyklen möglichst viele Bauelemente aufgenommen und gesetzt werden, also "Lücken" bei der Bestückung vermieden werden, um somit die Zahl der zur Bestückung aller Bauelemente erforderlichen Zyklen zu minimieren.

Ein Verfahren zur Überprüfung der sogenannten Consecutive-Ones-Eigenschaft ist in [1] beschrieben. Liegt die Consecutive-Ones-Eigenschaft vor, so liefert das Verfahren aus [1] implizit sämtliche zulässigen Ordnungen auf den Bauelementtypen.

Aus [2] ist ein Verfahren zur Überprüfung der sogenannten azyklischen Hypergraph-Eigenschaft bekannt, welches eine lineare Komplexität aufweist.

Aus [3] ist ein Verfahren zur Lösung eines Flußproblems bekannt.

In [4] ist ein sogenanntes Branch-and-Cut-Verfahren zur optimalen Lösung eines ganzzahligen lineares Programms bekannt.

Der Erfindung liegt das Problem zugrunde, für einen Bestükkungskopf und eine. vorgegebene Menge durch ihn zu setzender Bauelemente ein Verfahren und eine Vorrichtung zur Auswahl der an dem Bestückungskopf zu rüstenden Pipetten und zur Zuordnung der Bauelemente zu den in der Pipettenauswahl vorkommenden Pipettenarten anzugeben, mit dem bzw. mit der eine Bestückung einer Leiterplatte mit den vorgegebenen Bauelementen mit einer möglichst geringen Anzahl von Zyklen erreicht wird.

Das Problem wird durch die Verfahren mit den Merkmalen gemäß den unabhängigen Patentansprüchen sowie durch die Vorrichtungen mit den Merkmalen gemäß den unabhängigen Patentansprüchen gelöst.

Ein Verfahren zur rechnergestützten Pipettenauswahl für einen Bestückungskopf eines Bestückungsautomaten und zur Zuordnung von Bauelementen zu den in einer Pipettenauswahl vorgegebenen Pipettenarten bei einer vorgegebenen Zyklenzahl z, umfaßt folgende Schritt:

unter Verwendung

- einer gespeicherten Bauelementtypen-Liste B mit jeweils zugehöriger Anzahl zu setzender Bauelemente des Bauelementtyps,
- einer Bauelementtypen-Ordnung auf den Bauelementtypen,
- einer gespeicherten Pipettenarten-Liste P von zur Verfügung stehenden Pipettenarten und einer Zuordnungsliste E, die angibt, welche Bauelementtypen mit welchen Pipettenarten gesetzt werden können,

wird ausgehend von der Bauelementtypen-Ordnung für die Pipettenarten $p \in P$ eine Pipettenarten-Ordnung gebildet, derart, daß gilt:

$$p_1 \leq p_2 \Rightarrow (l(p_1)<l(p_2)) \vee ((l(p_1)=1(p_2)) \wedge f(p_1)\geq f(p_2))),$$

wobei

- $p1, p2 \in P$ unterschiedliche Pipettenarten bezeichnen,
- $l(p), p \in P$, definiert ist durch

$$l(p) = \max \{b \in B \mid (b, p) \in E\},$$

- $f(p), p \in P$, definiert ist durch

$$f(p) = \min \{b \in B \mid (b, p) \in E\},$$

sukzessive werden die Bauelemente in einer Reihenfolge, die durch die Bauelementtypen-Ordnung gegeben ist, den Pipettenarten auf folgende Weise zugeordnet:
existieren für einen Bauelementtypen Pipettenarten, denen nicht ein beliebiges Vielfaches der Zyklenzahl z viele Bauelemente bereits zugeordnet sind, so werden zunächst diesen Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;
verbleiben dann noch Bauelemente dieses Bauelementtyps, so werden diese der gemäß der Pipettenarten-Ordnung letzten möglichen Pipettenart zugeordnet, und
aus der Anzahl der einer Pipettenart zugeordneten Bauelemente wird eine Anzahl von Pipetten, die von der Pipettenart auszuwählen ist, ermittelt.

Ein weiteres Verfahren zur rechnergestützten Pipettenauswahl für einen Bestückungskopf eines Bestükkungsautomaten und zur Zuordnung von Bauelementen zu den in einer Pipettenauswahl vorgegebenen Pipettenarten bei einer vorgegebenen Zyklenzahl z, umfaßt folgende Schritt:

unter Verwendung

- einer gespeicherten Bauelementtypen-Liste B mit jeweils zugehöriger Anzahl zu setzender Bauelemente des Bauelementtyps,
- einer gespeicherten Pipettenarten-Liste P von zur Verfügung stehenden Pipettenarten und einer Zuordnungsliste E, die angibt, welche Bauelementtypen mit welchen Pipettenarten gesetzt werden können,

wird überprüft, ob eine zulässige Bauelementtypen-Ordnung existiert, d.h., ob gilt:

$$(b1, p) \in E, (b2, p) \in E, b1 \le b \le b2 \Rightarrow (b, p) \in E,$$

wobei mit

-- $b1, b2, b$ Bauelemente der Bauelementtypen-Liste B bezeichnet werden,
-- $(b, p) \in E, b \in B, p \in P$, den Fall bezeichnet, daß ein Bauelement vom Bauelementtypen b mit einer Pipette der Pipettenart p gesetzt werden kann,

ausgehend von der zulässigen Bauelementtypen-Ordnung für die Pipettenarten $p \in P$ wird eine Pipettenarten-Ordnung gebildet, derart, daß gilt:

$$p_1 \le p_2 \Rightarrow (l(p_1)<l(p_2)) \vee ((l(p_1)=l(p_2)) \wedge f(p_1) \ge f(p_2))),$$

wobei

- $p1, p2 \in P$ unterschiedliche Pipettenarten bezeichnen,
- $l(p), p \in P$, definiert ist durch

$$l(p) = \max \{b \in B \mid (b, p) \in E\},$$

- $f(p), p \in P$, definiert ist durch

$$f(p) = \min \{b \in B \mid (b, p) \in E\},$$

sukzessive werden die Bauelemente in einer Reihenfolge, die durch die Bauelementtypen-Ordnung gegeben ist, den Pipettenarten auf folgende Weise zugeordnet:

existieren für einen Bauelementtypen Pipettenarten, denen nicht ein beliebiges Vielfaches der Zyklenzahl z viele Bauelemente bereits zugeordnet sind, so werden zunächst diese Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;
verbleiben dann noch Bauelemente dieses Bauelementtyps, so werden diese der gemäß der Pipettenarten-Ordnung letzten möglichen Pipettenart zugeordnet, und
aus der Anzahl der einer Pipettenart zugeordneten Bauelemente wird eine Anzahl von Pipetten, die von der Pipettenart auszuwählen sind, ermittelt.

Eine Vorrichtung zur rechnergestützten Pipettenauswahl für einen Bestückungskopf eines Bestückungsautomaten und zur Zuordnung von Bauelementen zu den in einer Pipettenauswahl vorgegebenen Pipettenarten bei einer vorgegebenen Zyklenzahl z, enthält

- einen Speicher zur Speicherung einer Bauelementtypen-Liste B, einer Pipettenarten-Liste P, und einer Zuordnungsliste E,
- einen mit dem Speicher gekoppelten Prozessor, der derart eingerichtet ist, daß folgende Schritte durchführbar sind: unter Verwendung
- der gespeicherten Bauelementtypen-Liste B mit jeweils zugehöriger Anzahl zu setzender Bauelemente des Bauelementtyps,
- einer Bauelementtypen-Ordnung auf den Bauelementtypen,
- der gespeicherten Pipettenarten-Liste P von zur Verfügung stehenden Pipettenarten und der Zuordnungsliste E, die angibt, welche Bauelementtypen mit welchen Pipettenarten gesetzt werden können,

wird ausgehend von der Bauelementtypen-Ordnung für die Pipettenarten $p \in P$ eine Pipettenarten-Ordnung gebildet, derart, daß gilt:

$$p_1 \leq p_2 \Rightarrow (l(p_1)<l(p_2)) \vee ((l(p_1)=l(p_2)) \wedge f(p_1)\geq(p_2))),$$

wobei

- p1, p2 $\in$ P unterschiedliche Pipettenarten bezeichnen,
- $l(p)$, $p \in P$, definiert ist durch

$$l(p) = \max \{b \in B \mid (b, p) \in E\},$$

- $f(p)$, $p \in P$, definiert ist durch

$$f(p) = \min \{b \in B \mid (b, p) \in E\},$$

bei dem sukzessive die Bauelemente in einer Reihenfolge, die durch die Bauelementtypen-Ordnung gegeben ist, den Pipettenarten auf folgende Weise zugeordnet werden:

existieren für einen Bauelementtypen Pipettenarten, denen nicht ein beliebiges Vielfaches der Zyklenzahl z viele Bauelemente bereits zugeordnet sind, so werden zunächst diese Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;
verbleiben dann noch Bauelemente dieses Bauelementtyps, so werden diese der gemäß der Pipettenarten-Ordnung letzten möglichen Pipettenart zugeordnet, und
bei dem aus der Anzahl der einer Pipettenart zugeordneten Bauelemente eine Anzahl von Pipetten, die von der

Pipettenart auszuwählen sind, ermittelt wird.

Eine weitere Vorrichtung zur rechnergestützten Pipettenauswahl für einen Bestückungskopf eines Bestükkungsautomaten und zur Zuordnung von Bauelementen zu den in einer Pipettenauswahl vorgegebenen Pipettenarten bei einer vorgegebenen Zyklenzahl z, enthält

- einen Speicher zur Speicherung einer Bauelementtypen-Liste B, einer Pipettenarten-Liste P, und einer Zuordnungsliste E,
- einen mit dem Speicher gekoppelten Prozessor, der derart eingerichtet ist, daß folgende Schritte durchführbar sind: unter'Verwendung
- einer gespeicherten Bauelementtypen-Liste B mit jeweils zugehöriger Anzahl zu setzender Bauelemente des Bauelementtyps,
- einer gespeicherten Pipettenarten-Liste P von zur Verfügung stehenden Pipettenarten und einer Zuordnungsliste E, die angibt, welche Bauelementtypen mit welchen Pipettenarten gesetzt werden können,

wird überprüft, ob eine zulässige Bauelementtypen-Ordnung existiert, d.h., ob gilt:

$$(b1, p) \in E, (b2, p) \in E, b1 \leq b \leq b2 \Rightarrow (b, p) \in E,$$

wobei mit

-- b1, b2, b Bauelemente der Bauelementtypen-Liste B bezeichnet werden,
-- (b, p) ∈ E, b ∈ B, p ∈ P, den Fall bezeichnet, daß ein Bauelement vom Bauelementtypen b mit einer Pipette der Pipettenart p gesetzt werden kann,

bei dem ausgehend von der zulässigen Bauelementtypen-Ordnung für die Pipettenarten p ∈ P eine Pipettenarten-Ordnung gebildet wird, derart, daß gilt: .

$$p_1 \leq p_2 \Rightarrow (l(p_1)<l(p_2)) \vee ((l(p_1)=l(p_2)) \wedge f(p_1)\geq f(p_2))),$$

wobei

- p1, p2 ∈ P unterschiedliche Pipettenarten bezeichnen,
- l(p), p ∈ P, definiert ist durch

$$l(p) = \max \{b \in B \mid (b, p) \in E\},$$

- f(p), p ∈ P, definiert ist durch

$$f(p) = \min \{b \in B \mid (b, p) \in E\},$$

bei dem sukzessive die Bauelemente in einer Reihenfolge, die durch die Bauelementtypen-Ordnung gegeben ist, den Pipettenarten auf folgende Weise zugeordnet werden:

existieren für einen Bauelementtypen Pipettenarten, denen nicht ein beliebiges Vielfaches der Zyklenzahl z viele Bauelemente bereits zugeordnet sind, so werden zunächst diese Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;
verbleiben dann noch Bauelemente dieses Bauelementtyps, so werden diese der gemäß der Pipettenarten-Ordnung letzten möglichen Pipettenart zugeordnet, und
bei dem aus der Anzahl der einer Pipettenart zugeordneten Bauelemente eine Anzahl von Pipetten, die von der Pipettenart auszuwählen sind, ermittelt wird.

Die Erfindung zeichnet sich dadurch aus, daß die Bestückung einer Leiterplatte mit vorgegebenen Baule-

menten in einer möglichst geringen Zahl von Zyklen, teilweise sogar in einer optimalen Zahl von Zyklen durchgeführt werden kann, was zu einer erheblichen Beschleunigung der Bestückung führt.

Das Verfahren gemäß Patentanspruch 2 überprüft die sog. Consecutive-Ones-Eigenschaft der möglichen Zuordnungen der Bauelemente zu den jeweiligen vorgegebenen Pipettenarten, d.h. es untersucht die Frage, ob eine zulässige Bauelementen-Typen-Ordnung existiert.

Bevorzugte Weiterbildungen der Erfindung ergeben sich aus den abhängigen Ansprüchen.

Ist die Consecutive-Ones-Eigenschaft nicht erfüllt, so ist es in einer Weiterbildung vorteilhaft, die Menge E der möglichen Zuordnungen von Bauelementtypen zu Pipettenarten zu verkleinern: ausgehend von den Bauelementtypen und den Pipettenarten sukzessive für jede Pipettenart so viele Bauelemente wie möglich der jeweiligen Pipettenart zugeordnet werden, so daß zur resultierenden Zuordnungsliste E eine Bauelementtypen-Ordnung auf den Bauelementtypen existiert derart, daß gilt:

$$(b1, p) \in E, (b2, p) \in E, b1 \leq b \leq b2 \Rightarrow (b, p) \in E.$$

Für die Pipettenarten $p \in P$ wird im Rahmen dieser Weiterbildung eine Pipettenarten-Ordnung gebildet derart, daß gilt:

$$p_1 \leq p_2 \Rightarrow (l(p_1)<l(p_2)) \vee ((l(p_1)=l(p_2)) \wedge f(p_1)\geq f(p_2))),$$

und die Bauelemente werden in einer Reihenfolge, die durch die Bauelementtypen-Ordnung gegeben ist, den Pipettenarten auf folgende Weise zugeordnet:

existieren für einen Bauelementtypen Pipettenarten, denen nicht ein beliebiges Vielfaches der Zyklenzahl z viele Bauelemente bereits zugeordnet sind, so werden zunächst diese Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;

verbleiben dann noch Bauelemente dieses Bauelementtyps, so werden diese der gemäß der Pipettenarten-Ordnung letzten möglichen Pipettenart zugeordnet. Aus der Anzahl der einer Pipettenart zugeordneten Bauelemente wird eine Anzahl von Pipetten, die von der Pipettenart auszuwählen sind, ermittelt.

Diese Weiterbildung, die zwar eine optimale Lösung nicht mehr gewährleistet hat in der Praxis sehr gute Ergebnisse gezeigt.

Weiterhin kann für den Fall, daß die zulässige Bauelementtypen-Ordnung nicht existiert, die zu ermittelnde Lösung durch Lösung einer Folge von Flußproblemen bestimmt werden.

Es kann für den Fall, daß die zulässige Bauelementtypen-Ordnung nicht existiert, geprüft werden, ob für mögliche Zuordnungen der Bauelementtypen zu den Pipettenarten gemäß der Zuordnungsliste E eine Menge von Bäumen mit den Pipettenarten als Knoten der Bäume ermittelt werden kann, so daß jeder von einer Menge von Pipettenarten P(b), die ein Bauelement b setzen können, induzierte Teilgraph der Menge der Bäume zusammenhängend ist, und, wenn eine solche Menge von Bäumen ermittelt werden kann, dir Pipettenarten danach topologisch sortiert werden können und die zu ermittelnde Lösung durch Lösung einer Folge von Flußproblemen bestimmt wird.

Durch diese Ausgestaltung wird eine Bestückung mit einer minimalen Zahl benötigter Zyklen erreicht.

In einer weiteren bevorzugten Ausgestaltung ist es vorgesehen, daß für den Fall, daß die zulässige Ordnung nicht existiert, geprüft wird, ob für mögliche Zuordnungen der Bauelementtypen zu den Pipettenarten gemäß der Zuordnungsliste eine Menge von Bäumen mit den Pipettenarten als Knoten der Bäume ermittelt werden kann, so daß jeder von einer Menge von Pipettenarten P(b), die ein Bauelement b setzen können, induzierte Teilgraph der Menge der Bäume zusammenhängend ist. Wenn eine solche Menge von Bäumen nicht ermittelt werden kann, werden Elemente aus der Zuordnungsliste E gelöscht, bis eine solche Menge von Bäumen ermittelt werden kann. Die zu ermittelnde Lösung wird durch Lösung einer Folge von Flußproblemen bestimmt.

Diese Weiterbildung, die zwar eine optimale Lösung nicht mehr gewährleistet hat in der Praxis sehr gute Ergebnisse gezeigt.

Das Flußproblem kann gemäß folgenden Vorschriften gebildet werden:

$$\sum_{p:(b,p)\in E} x_{bp} = n_b \qquad \forall\ b \in B$$

$$\sum_{p:(b,p)\in E} x_{bp} \le c_p \qquad \forall\ p \in P$$

wobei

- $n_b$ eine Zahl der zu setzenden Bauelemente vom Bauelementtypen b ∈ B angibt,
- cp, p ∈ P, eine vorgebbare Schranke, durch deren Variation die Folge von Flußproblemen gebildet wird, bezeichnet,
- eine erste Lösungsvariable $x_{bp}$ angibt, wie viele Bauelemente vom Bauelementtypen b ∈ E durch eine Pipette der Pipettenart p ∈ P gesetzt werden.

Für den Fall, daß die zulässige Ordnung nicht existiert, kann geprüft werden, ob für mögliche Zuordnungen der Bauelementtypen zu den Pipettenarten gemäß der Zuordnungsliste eine Menge von Bäumen mit den Pipettenarten als Knoten der Bäume ermittelt werden kann, so daß jeder von einer Menge von Pipettenarten P(b), die ein Bauelement b setzen können, induzierte Teilgraph der Menge der Bäume zusammenhängend ist. Wenn eine solche Menge von Bäumen nicht ermittelt werden kann, kann die zu ermittelnde Lösung durch Lösen eines linearen Programms ermittelt werden.

Das lineare Programm kann gemäß folgender Vorschriften gebildet werden:

$$\sum_{p:(b,p)\in E} x_{bp} = n_b \qquad \forall\ b \in B$$

$$\sum_{p:(b,p)\in E} x_{bp} \le y_p \cdot z \qquad \forall\ p \in P$$

$$\sum_{p\in P} y_p \le k$$

wobei

- $n_b$ eine Zahl der zu setzenden Bauelemente vom Bauelementtypen b ∈ B angibt,
- eine erste Lösungsvariable $x_{bp}$ angibt, wie viele Bauelemente vom Bauelementtypen b ∈ B durch eine Pipette der Pipettenart p ∈ P gesetzt werden,
- eine zweite Lösungsvariable yp angibt, wie viele Pipetten der Pipettenart p ∈ P ausgewählt werden,
- k eine Zahl von Segmenten des Bestückungskopfs bezeichnet,
- x, y ≥ 0, ganzzahlig ist.

Auch mit dieser Weiterbildung wird gewährleistet, daß die Bestückung mit der optimalen Anzahl von Zyklen durchführbar wird.

Die Weiterbildungen gelten sowohl für die Verfahren als auch für die Vorrichtungen, wobei jeweils der Prozessor derart eingerichtet ist, daß die Verfahren gemäß der Weiterbildung durchgeführt werden können.

In den Figuren ist ein Ausführungsbeispiel der Erfindung dargestellt, das im weiteren näher erläutert wird.

Es zeigen

Figur 1 ein Ablaufdiagramm, in dem die Verfahrensschritte des Ausführungsbeispiels dargestellt sind;

Figur 2 eine Skizze eines Bestückungsautomaten;

Figuren 3a und 3b eine Skizze mögliche Zuordnungen von Bauelementen zu Pipettenarten, die die Consecutive-Ones-Eigenschaft erfüllen;

Figuren 4a und 4b eine Skizze möglicher Zuordnungen von Bauelementen und Pipettenarten vor und nach der Sortierung der Pipettenarten;

Figuren 5a und 5b eine Skizze möglicher Zuordnungen, die die Azyklische-Hypergraph-Eigenschaft erfüllen.

**Fig.2** zeigt einen Bestückungsautomaten 201 mit einem Förderbereich 202, die Förderer enthalten mit Bauelementespeichern. In den Bauelementespeichern sind Bauelemente enthalten, die von dem Bestückungsautomaten 201 auf einer Leiterplatte 203 an vorgegebenen Bestückpositionen 204 gesetzt werden. Die Bauelemente 205 werden von einem Bestückungskopf - einem SP-Kopf oder einem IC-Kopf - aufgenommen, zu den Bestückpositionen transportiert und an der jeweiligen Bestückposition auf die Leiterplatte 203 gesetzt.

Der Bestückungskopf weist Segmente auf zur Aufnahme von Pipetten unterschiedlicher Pipettenarten $p \in P$, mit denen jeweils unterschiedliche Bauelemente aufgenommen, transportiert und gesetzt werden können.

Verschiedene Bauelementtypen, die jeweils mit derselben Menge von Pipettenarten gesetzt werden können, können zu sogenannten Bauelementenklassen zusammengefaßt werden und gemeinsam wie ein Bauelementtyp behandelt werden.

Es gilt also: zwei Bauelemente gehören zur selben Bauelementeklasse, wenn sie mit genau denselben Pipettenarten gesetzt werden können.

Der Bestückungsautomat 201 weist eine Vorrichtung 206 auf, mit einem Speicher 207 und einer Prozessor 208, die mit dem Speicher 207 verbunden ist.

In dem Speicher 207 sind folgende Listen gespeichert:

- Eine Bauelementtypen-Liste B, in der die Bauelementtypen, mit denen die Leiterplatte 203 bestückt werden soll, gemeinsam mit der jeweiligen Anzahl Bauelemente gespeichert sind.

- Eine Pipettenarten-Liste P, in der die zur Verfügung stehenden Pipettenarten gespeichert sind.

- Eine Zuordnungsliste E, in der angegeben ist, welche Bauelementtypen mit welchen Pipettenarten gesetzt werden können.

Gemäß dem im weiteren beschriebenen Verfahren werden die für die Bestückung der Leiterplatte 203 auf dem SP-Bestückungskopf zu rüstenden Pipetten ermittelt. Der Bestükkungskopf wird mit den Pipetten der entsprechenden Pipettenarten gerüstet, und die Leiterplatte 203 wird mit den Bauelementen 205 gemäß der vorgegebenen Bestückung und den vorgegebenen Bestückpositionen 204 bestückt.

Die Zuordnungsliste E kann zum einfacheren Verständnis in Form eines bipartiten Graphen dargestellt werden (vgl. **Fig.3a** und **Fig.3b**).

Knoten auf der linken Seite des Graphen (vgl. **Fig.3a**) bezeichnen Bauelementtypen und Knoten auf der rechten Seite des bipartiten Graphen bezeichnen Pipettenarten. Verbindungen zwischen den Knoten der linken und der rechten Seite des Graphen geben an, daß ein Bauelement des jeweiligen Bauelementtyps mit einer Pipette der jeweiligen Pipettenart gesetzt werden kann.

Zur Zuordnung der Bauelemente zu den Pipetten und somit zur Auswahl der Pipetten verschiedener Pipettenarten zur Bestükkung der Leiterplatte 203 wird das Verfahren, das in seinen Verfahrensschritten in **Fig.1** dargestellt ist, durchgeführt.

Eine Bestückung erfolgt in mindestens einem Zyklus, wobei ein Zyklus jeweils einen Durchgang bezeichnet, bei dem der Bestückungskopf eine vorgebbare Anzahl, maximal seine Kapazität, an Bauelementen aufnimmt, transportiert und an den entsprechenden, vorgegebenen Bestückpositionen 204 der Leiterplatte 203 setzt.

Ziel ist es, die Zahl benötigter Zyklen für eine Bestückung möglichst gering zu halten. Das im weiteren beschriebene Verfahren wird iterativ für mindestens eine vorgebbare Anzahl Zyklen durchgeführt.

Dabei wird folgende Vorgehensweise gewählt, mit der für die vorgegebene Zahl von Zyklen eine Lösung des Pipetten-Auswahlproblems, das im weiteren erläutert wird, bestimmt wird, bzw. festgestellt wird, daß eine solche Lösung für die vorgegebene Zahl von Zyklen nicht existiert.

Existiert eine Lösung, so ist das Verfahren beendet, wird keine Lösung ermittelt, so wird die Zahl der Zyklen solange erhöht und das Verfahren zur Lösung des Pipetten-Auswahlproblems durchgeführt, bis eine Zahl von Zyklen ermittelt wurde, für die eine Lösung existiert.

Anschaulich kann diese Vorgehensweise folgendermaßen formuliert werden. Es wird für die minimale Anzahl z von Zyklen eine triviale untere Schranken us und eine obere Schranke os angegeben.

Das Verfahren erfolgt gemäß folgenden Schritten:

1. Setze z = us.
2. Finde eine zulässige Lösung für das Pipetten-Auswahlproblem. Falls eine zulässige Lösung nicht existiert und die obere Schranke os für die Zahl z der Zyklen noch nicht erreicht ist, setze z = z + 1 und wiederhole Schritt 2.

Es hat sich herausgestellt, daß zumeist die optimale Zyklenzahl durch die untere Schranke us selbst oder durch us + 1 gegeben ist, so daß meistens eine oder zwei Iterationen des Verfahrens zur Ermittlung einer Lösung des Pipetten-Auswahlproblems ausreichen.

In jeder Iteration, d.h. jeweils für eine vorgegebene Zahl von Zyklen, wird das im weiteren beschriebene Verfahren zur Ermittlung der Zuordnung der Bauelemente zu den Pipetten durchgeführt.

In einem ersten Schritt (Schritt 101) wird für die möglichen Zuordnungen der Bauelementtypen zu den verschiedenen Pipettenarten überprüft, ob die Consecutive-Ones-Eigenschaft erfüllt ist.

Die Consecutive-Ones-Eigenschaft ist gegeben falls gilt:

Es kann eine Bauelementtypen-Ordnung auf der Menge der Bauelementtypen angegeben werden, so daß gilt

$$(b1, p) \in E, (b2, p) \in E, b1 \leq b \leq b2 \Rightarrow (b, p) \in E,$$

wobei mit

- **--** b1, b2, b Bauelemente der Bauelementtypen-Liste B bezeichnet werden,
- **--** $(b, p) \in E$, $b \in B$, $p \in P$, den Fall bezeichnet, daß ein Bauelement vom Bauelementtypen b mit einer Pipette der Pipettenart p gesetzt werden kann,

Eine solche Bauelementtypen-Ordnung wird im weiteren als zulässige Bauelementtypen-Ordnung bezeichnet.

**Fig.3a** und **Fig.3b** stellen ein Beispiel dar einer möglichen Zuordnung, die die Consecutive-Ones-Eigenschaft erfüllt.

Die beiden bipartiten Graphen **(Fig.3a, Fig.3b)** stellen die Bauelementtypen bj (j = 1, ..., m) die Pipettenarten pi (i = 1, ..., n) und die Menge der zulässigen Zuordnungen der Bauelementtypen zu den Pipettenarten dar.

In dem Graphen in **Fig.3b** sind die Bauelementtypen derart angeordnet, daß für alle Pipettenarten $p \in P$ die Bauelementtypen, die mit einer Pipette der jeweiligen Pipettenart $p \in P$ gesetzt werden können, unmittelbar aufeinanderfolgen. Die Consecutive-Ones-Eigenschaft ist demnach gegeben.

Zur Überprüfung der Consecutive-Ones-Eigenschaft wird das in [1] beschriebene Verfahren eingesetzt, mit dem ein Datensatz in linearer Laufzeit auf die Consecutive-Ones-Eigenschaft hin überprüft werden kann. Liegt die Consecutive-Ones-Eigenschaft vor, so liefert das Verfahren aus [1] implizit sämtliche zulässigen Ordnungen auf den Bauelementtypen.

Liegt eine Instanz des Pipetten-Auswahlproblems mit Consecutive-Ones-Eigenschaft vor, so wird in einem zweiten Schritt (Schritt 102) ein im weiteren als inverses Greedy-Verfahren bezeichnetes und in seinen Verfahrensschritten detailliert erläutertes Verfahren durchgeführt.

Mit dem inversen Greedy-Verfahren wird für eine vorgegebene Zyklenzahl z eine minimale,Zahl von Pipetten, die erforderlich ist, um alle zu setzenden Bauelemente mit z Zyklen zu setzen, bestimmt. Gleichzeitig werden die entsprechenden Zuordnungen der Bauelemente zu den Pipetten der verschiedenen Pipettenarten sowie die Zahl der Pipetten der jeweiligen Pipettenart $p \in P$ ermittelt.

Ist die Zahl der erforderlichen Pipetten nicht größer als die Zahl der Segmente an dem Bestückungskopf, so ist eine Lösung des Pipetten-Auswahlproblems für z Zyklen gefunden, andernfalls existiert eine solche Lösung nicht.

Bevor das Verfahren durchgeführt wird, wird für die Pipettenarten eine Pipettenarten-Ordnung gebildet derart, daß gilt:

$$p_1 \leq p_2 \Rightarrow (l(p_1)<l(p_2)) \vee ((l(p_1)=l(p_2)) \wedge f(p_1)\geq f(p_2))),$$

wobei

- p1, p2 ∈ P unterschiedliche Pipettenarten bezeichnen,
- l(p), p ∈ P, definiert ist durch

$$l(p) = \max \{b \in B \mid (b, p) \in E\},$$

- f(p), p ∈ P, definiert ist durch

$$f(p) = \min \{b \in B \mid (b, p) \in E\}.$$

**Fig.4a** und **Fig.4b** zeigen das in den **Fig.3a** und **Fig.3b** begonnene Beispiel hinsichtlich der Pipettenarten-Ordnung. Beim Graphen in **Fig.4b** sind neben den Bauelementtypen auch die Pipettenarten geeignet angeordnet.

Bei dem inversen Greedy-Verfahren (Schritt 102) werden sukzessive die Bauelemente in einer Reihenfolge, die durch die Bauelementtypen-Ordnung gegeben ist, den Pipettenarten auf folgende Weise zugeordnet:

- existieren für einen Bauelementtypen Pipettenarten, denen nicht ein beliebiges Vielfaches der Zyklenzahl z viele Bauelemente bereits zugeordnet sind, so werden zunächst diese Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;
- verbleiben dann noch Bauelemente dieses Bauelementtyps, so werden diese der gemäß der Pipettenarten-Ordnung letzten möglichen Pipettenart zugeordnet.

Das folgende Programmstück zeigt eine mögliche Realisierung des inversen Greedy-Verfahrens in Form eines Computerprogramms in der Programmiersprache C.

Eine erste Lösungsvariable $x_{bp}$, eine zweite Lösungsvariable $y_p$, Parameter $n_b$, $t_b$, etc. sind in dem Programmstück mit x[bp], y[p], n[b], t[b]·etc. Bezeichnet. Dabei ist $t_b$ durch $tb = \max \{p \in P \mid (b, p) \in E\}$ definiert.

```
for (j = 1; j ≤ |P|; j++)
     {
     for (i = f[p[j]]; i ≤ l[p[j]]; i++)
          {
          if ( p[j] == t(b[i]) )
             {
             x[b[i], p[j]] = n[b[i]];
             m[p[j]] += x[b[i], p[j]];
             n[b[i]] -= x[b[i], p[j]];
             }
          else
             break;
          }
     while ( (i ≤ |B|) && (m[p[j]] mod z != 0) )
          {
          gap = z - (m[p[j]] mod z);
          x[b[i], p[j]] = min{n[b[i]], gap};
          m[p[j]] += x[b[i], p[j]];
          n[b[i]] -= x[b[i], p[j]];
          i = i + 1;
          }
     y[p[j]] = ⌈ m[p[j]] / z⌉;
     }
```

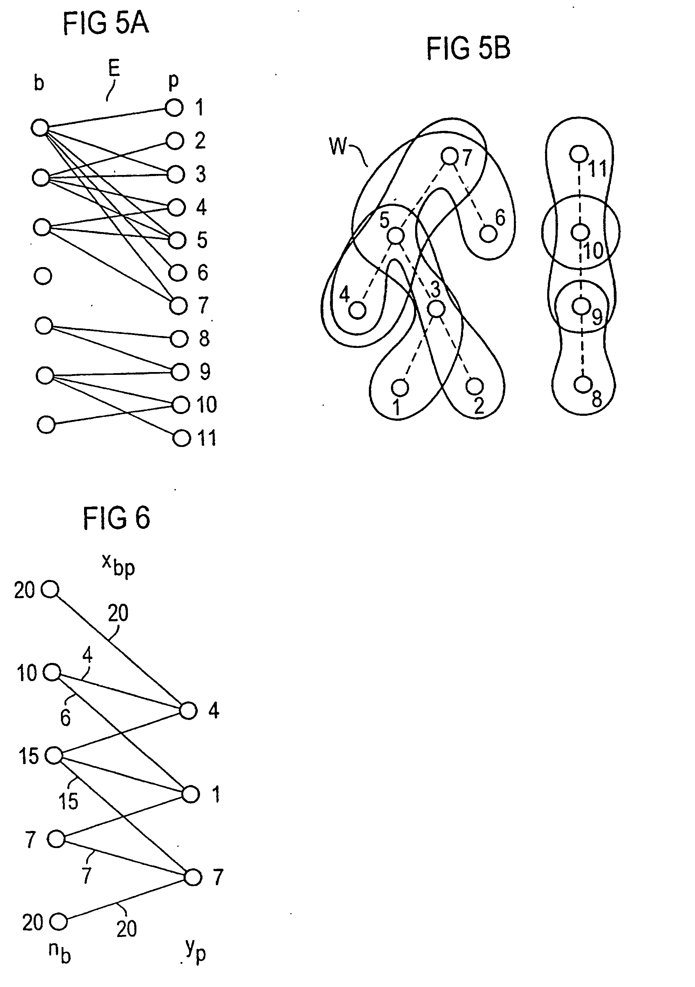

In **Fig.6a** ist für ein weiteres einfaches Beispiel das inverse Greedy-Verfahren und die sich daraus ergebende Zuordnung in einem Graphen dargestellt. Es wird folgende Ausgangssituation angenommen.

Für die 5 Bauelementtypen sind jeweils eine durch eine Zahl angegebene Anzahl von Bauelementen angegeben, die auf der Leiterplatte 203 zu bestücken sind. Dies bedeutet, daß in diesem Beispielsfall folgende Bauelemente des jeweiligen Bauelementtyps bestückt werden müssen:

- erster Bauelementtyp: 20 Bauelemente;
- zweiter Bauelementtyp: 10 Bauelemente;
- dritter Bauelementtyp: 15 Bauelemente;
- vierter Bauelementtyp: 7 Bauelemente;
- fünfter Bauelementtyp: 20 Bauelemente.

Es stehen zur Bestückung drei verschiedene Pipettenarten zur Verfügung. Die Zahl an den Knoten, mit denen die Pipettenarten bezeichnet werden, gibt jeweils die durch das Verfahren ermittelte Zahl $y_p$ (zweite Lösungsvariable) der Pipetten der jeweiligen Pipettenart an.

Es ergibt sich somit folgende Verteilung von Pipetten auf die verschiedenen Pipettenarten:

- erste Pipettenart: 4 Pipetten;
- zweite Pipettenart: 1 Pipette;
- dritte Pipettenart: 7 Pipetten.

In diesem Beispielsfall wird eine Zuordnung für 6 Zyklen ermittelt.

Die Bauelemente des ersten Bauelementtyps können nur mit Pipetten der ersten Pipettenart, wie durch die Verbindung der beiden Knoten des Graphen dargestellt, gesetzt werden.

Die Bauelemente des zweiten Bauelementtyps können sowohl durch Pipetten der ersten als auch der zweiten Pipettenart gesetzt werden.

Bauelemente des dritten Bauelementtyps können von Pipetten sowohl der ersten, als auch der zweiten oder der dritten Pipettenart gesetzt werden.

Bauelemente des vierten Bauelementtyps können durch Pipetten der zweiten Pipettenart und durch Pipetten der dritten Pipettenart gesetzt werden.

Bauelemente des fünften Bauelementtyps können nur durch Pipetten der dritten Pipettenart gesetzt werden.

Bei dem inversen Greedy-Verfahren 102 wird begonnen mit den Bauelementen des ersten Bauelementtyps, für die alle Bauelemente den Pipetten der ersten Pipettenart in den sechs Zyklen zugeordnet werden. Insgesamt werden vier Pipetten der ersten Pipettenart in den sechs Zyklen (6 x 4 = 24) benötigt, um alle 20 Bauelemente des ersten Bauelementtyps mit den Pipetten der ersten Pipettenart zu setzen. Somit werden die 20 Bauelemente des ersten Bauelementtyps den Pipetten der ersten Pipettenart zugeordnet.

Anschließend werden die Bauelemente des zweiten Bauelementtyps (10 Bauelemente) den Pipetten zugeordnet. Die Pipetten der ersten Pipettenart haben in den sechs Zyklen noch eine freie Kapazität von vier Bauelementen (24 - 20 = 4 Bauelemente), die in den sechs Zyklen von Pipetten der ersten Pipettenart gesetzt werden können. Vier der 10 Bauelemente des zweiten Bauelementtyps werden somit den Pipetten der ersten Pipettenart zugeordnet, da bei der Zuordnung, wenn möglich, die Pipetten mit den Bauelementen "aufgefüllt" werden. Die restlichen sechs Bauelemente des zweiten Bauelementtyps werden einer Pipette der zweiten Pipettenart zugeordnet, da eine Pipette der zweiten Pipettenart insgesamt in den sechs Zyklen sechs Bauelemente setzen kann.

In einem weiteren Schritt werden die Bauelemente des dritten Bauelementtyps (15 Bauelemente) den Pipetten zugeordnet. Die Pipetten der ersten Pipettenart und der zweiten Pipettenart sind schon belegt, so daß die 15 Bauelemente des dritten Bauelementtyps Pipetten der dritten Pipettenart zugeordnet werde. Hierfür sind sieben Pipetten der dritten Pipettenart erforderlich. Ebenso werden die sieben Bauelemente des vierten Bauelementtyps und die 20 Bauelemente des fünften Bauelementtyps Pipetten der dritten Pipettenart zugeordnet. Insgesamt können mit den sieben Pipetten der dritten Pipettenart 7 x 6 = 42 Bauelemente gesetzt werden. Dies ist genau die Anzahl an Bauelementen, die von Bauelementen des dritten Bauelementtyps, des vierten Bauelementtyps und des fünften Bauelementtyps gesetzt werden sollen.

Somit existiert eine Lösung für die Zuordnung gemäß dem inversen Greedy-Verfahren (Schritt 102) für 6 Zyklen und die Bestückung kann gemäß dieser Zuordnung im weiteren erfolgen. Das Ergebnis des Verfahrens ist gegeben durch die Anzahl der benötigten Pipetten der jeweiligen Pipettenarten und durch die Zuordnung der Bauelemente zu den Pipettenarten.

Es ist zu betonen, daß das inverse Greedy-Verfahren, wie im weiteren noch erläutert wird, für den Fall eine optimale Lösung des Pipetten-Auswahlproblems angibt, wenn für die möglichen Zuordnungen die Consecutive-Ones-Eigenschaft erfüllt ist.

Es kann lediglich nicht mehr gewährleistet werden, daß die Lösung eine optimale Lösung des Pipetten-Auswahlproblems im mathematischen Sinne darstellt, falls die Consecutive-Ones-Eigenschaft nicht erfüllt ist.

Ist die Consecutive-Ones-Eigenschaft (vgl. Schritt 101) nicht gegeben, so wird eine der Varianten (Schritt 103 oder Schritt 104), die im weiteren erläutert werden, durchgeführt.

Im Rahmen einer ersten Heuristik (Schritt 103) werden ausgehend von einem leeren Graphen, d.h. eine Menge von Bauelementtypen und Pipettenarten, jedoch ohne Zuordnungen, der die Consecutive-Ones-Eigenschaft trivialerweise erfüllt, sukzessive die einzelnen Pipettenarten $p \in P$ betrachtet und so viele Kanten $(p, b) \in E$ wie möglich dem Graphen hinzugefügt, ohne die Consecutive-Ones-Eigenschaft zu verlieren. Auf den resultierenden Graphen, der nun weniger Kanten als der ursprüngliche Graph enthält, jedoch die Consecutive-Ones-Eigenschaft erfüllt, wird nun das oben beschriebenen inverse Greedy-Verfahren durchgeführt.

Es kann in einer weiteren Variante des Verfahrens auch in einem weiteren Schritt (Schritt 104) derart vorgegangen werden, daß die möglichen Zuordnungen auf folgende Eigenschaft hin untersucht wird, die im weiteren als Azyklische-Hypergraph-Eigenschaft bezeichnet wird:

Es gibt eine Menge von Bäumen W (Wald W) mit den Pipettenarten P als Knoten, so daß jeder von einer Menge von Pipettenarten P(b), die ein Bauelement b setzen können, induzierte Teilgraph des Waldes W zusammenhängend ist.

Ist die Azyklische-Hypergraph-Eigenschaft erfüllt, so werden die Pipettenarten gemäß des Waldes W wopologisch sortiert, also eine lineare Ordnung für die Pipettenarten bestimmt.

Aus [2] ist ein Verfahren zur Überprüfung der Azyklischer-Hypergraph-Eigenschaft bekannt, welches eine lineare Komplexität aufweist.

Zur Verdeutlichung dieser Eigenschaft zeigen **Fig.5a** und **Fig.5b** zum einen eine Zuordnungsliste E mit Bauelementtypen und Pipettenarten **(Fig.5a)** und einen Wald mit den geforderten Eigenschaften; die Ziffern definieren eine gewünschte lineare Ordnung **(Fig.5b).**

Ist die Azyklischer-Hypergraph-Eigenschaft erfüllt, so wird in einem weiteren Schritt (Schritt 105) ein im weiteren als Greedy-Fluß-Verfahren beschriebenes Verfahren durchgeführt. Das Pipetten-Auswahlproblem wird als eine Folge $PAP_C$ von Flußproblemen gemäß folgenden Vorschriften formuliert:

($PAP_C$)

$$\sum_{p:(b,p)\in E} x_{bp} = n_b \qquad \forall\ b \in B$$

$$\sum_{p:(b,p)\in E} x_{bp} \le c_p \qquad \forall\ p \in P$$

wobei

- $n_b$ eine Zahl der zu setzenden Bauelemente vom Bauelementtypen $b \in E$ angibt,
- cp, $p \in P$ eine vorgebbare Schranke, durch deren Variation die Folge von Flußproblemen gebildet wird, bezeichnet wird,
- eine erste Lösungsvariable $x_{bp}$ angibt, wie viele Bauelemente vom Bauelementtypen $b \in B$ durch eine Pipette der Pipettenart $p \in P$ gesetzt werden.

Zur Lösung eines solchen Flußproblems wird das in [3] beschriebene Verfahren eingesetzt.

Zur Lösung des Pipettenauswahl-Problems wird das im folgenden dargestellte Computerprogramm eingesetzt werden, in dem eine Folge von Flußproblemen des obigen Typs gelöst wird, wobei die Schranken $c_p$ (im Programm c[p]) variiert werden. Die lineare Ordnung der Pipettenarten sei durch $p_1 \le p_2 \le ... \le p_{|P|}$ gegeben

```
for ( j = 1; j ≤ |P|; j++)
     c[p[j]] = ⌈nges / z⌉ * z;
for ( j = 1; j ≤ |P|; j++)
     for (c[p[j]]=0; c[p[j]] ≤ ⌈nges / z⌉ * z; c[p[j]] += z)
          if (is_feasible(PAPC) )
             {
             y[p[j]] = c[p[j]] / z;
             break;
          }
```

Die Zuordnungen, d.h. die Werte für $x_{bp}$ ergeben sich aus der Lösung des jeweils letzten Flußproblems. Ferner gilt:

$$\text{Ist} \sum_{p \in P} y_p > k,$$

wobei k die Zahl von Segmenten des Bestückungskopfs bezeichnet, existiert keine Lösung mit der Zyklenzahl z.

Ergibt die Überprüfung auf die azyklische Hypergraph-Eigenschaft (Schritt 104) ein negatives Resultat, d.h. ist die Eigenschaft nicht erfüllt, so wird ein Verfahren aus zwei im weiteren beschriebenen möglichen Verfahren (Schritt 106 oder Schritt 107) durchgeführt.

In einer ersten Variante (Schritt 106) wird im Rahmen einer zweiten Heuristik ein Verfahren durchgeführt, bei dem aus dem Zuordnungsgraphen Kanten gelöscht wurden, so daß gemäß dem oben beschriebenen Verfahren ein Wald W mit der azyklischen Hypergraph-Eigenschaft gebildet werden kann. Es ist vorteilhaft, dabei darauf zu achten, daß möglichst wenig Kanten gelöscht werden. Anschließend wird das Greedy-Fluß-Verfahren auf den sich ergebenden Graphen durchgeführt.

Es ist zu betonen, daß das Greedy-Fluß-Verfahren für jede lineare Ordnung auf den Pipettenarten P ausgeführt werden kann. Es ist lediglich im allgemeinen Fall nicht gewährleistet, daß es keine Lösung gibt, wenn mit dem Greedy-Fluß-Verfahren keine Lösung gefunden wird. Trotzdem werden auch mit dem Greedy-Fluß-Verfahren sehr gute Ergebnisse erzielt.

Alternativ zu der zweiten Heuristik (Schritt 106) kann das Pipetten-Auswahlproblem als ein ganzzahliges lineares Programm formuliert und gelöst werden bzw. dessen Unzulässigkeit festgestellt werden. Das lineare Programm $PAP_z$ wird für das Pipetten-Auswahlproblem gemäß folgenden Vorschriften formuliert:

$$\sum_{p:(b,p) \in E} x_{bp} = n_b \qquad \forall\ b \in B$$

$$\sum_{p:(b,p) \in E} x_{bp} \leq y_p \cdot z \qquad \forall\ p \in P$$

$$\sum_{p \in P} y_p \leq k$$

wobei

- $n_b$ eine Zahl der zu setzenden Bauelemente vom Bauelementtypen $b \in E$ angibt,
- eine erste Lösungsvariable $x_{bp}$ angibt, wie viele Bauelemente vom Bauelementtypen $b \in B$ durch eine Pipette der Pipettenart $p \in P$ gesetzt werden,
- eine zweite Lösungsvariable yp angibt, wie viele Pipetten der Pipettenart $p \in P$ ausgewählt werden,
- k eine Zahl von Segmenten des Bestückungskopfs bezeichnet,
- $x,y \geq 0$, ganzzahlig ist.

Ein ganzzahliges lineares Programm wird durch das bekannte Branch-and-Cut-Verfahren optimal gelöst, wie es in [4] beschrieben ist.

Ist gemäß dem oben beschriebenen Verfahren die Zuordnung der Bauelemente zu den Pipetten der verschienden Pipettenarten und somit die Zuordnung der Pipetten bzw. Pipettenarten zu dem Bestückungskopf ermittelt, so wird die Bestückung gemäß dieser Zuordnung unter Verwendung der ermittelten Pipetten durchgeführt.

Die Auswahl der jeweiligen Verfahrensvariante erfolgt abhängig von der für die Durchführung des Verfahrens verfügbaren Rechenzeit.

Im Rahmen dieses Dokuments wurden folgende Veröffentlichungen zitiert:

[1] W.L. HSU, A Simple Test for teh Consecutive Ones Property, Lecture Notes in Computer Science: Algorithms and Computation, Vol. 650, S. 459-468, 1992

[2] R. E. Tarjan, M. Yannakakis, Simple Linear-Time Algorithms to Test Chordality of Graphs, Test Acyclicity of Hypergraphs, and Selectively Reduce Acyclic Hypergraphs, SIAM J. Comput., Vol. 13, S. 566-579, 1984

[3] R. K. Ahuja et al, Network Flows, Prentice Hall, S. 207 - 242 und 255 - 258, 1993

[4] G. L. Nemhauser, L. A. Wolsey, Integer and Combinatorial Optimization, Wiley, New York, S. 349 - 379, 1988

**Patentansprüche**

1. Verfahren zur rechnergestützten Pipettenauswahl für einen Bestückungskopf eines Bestückungsautomaten und zur Zuordnung von Bauelementen zu den in einer Pipettenauswahl vorgegebenen Pipettenarten bei einer vorgegebenen Zyklenzahl z, bei dem unter Verwendung

   - einer gespeicherten Bauelementtypen-Liste B mit jeweils zugehöriger Anzahl zu setzender Bauelemente des Bauelementtyps,
   - einer Bauelementtypen-Ordnung auf den Bauelementtypen,
   - einer gespeicherten Pipettenarten-Liste P von zur Verfügung stehenden Pipettenarten und einer Zuordnungsliste E, die angibt, welche Bauelementtypen mit welchen Pipettenarten gesetzt werden können,

   ausgehend von der Bauelementtypen-Ordnung für die Pipettenarten $p \in P$ eine Pipettenarten-Ordnung gebildet wird, derart, daß gilt:

   $$p_1 \leq p_2 \Rightarrow (l(p_1)<l(p_2)) \vee ((l(p_1)=l(p_2)) \wedge f(p_1)\geq f(p_2))),$$

   wobei

   - p1, p2 $\in$ P unterschiedliche Pipettenarten bezeichnen,
   - l(p), $p \in P$, definiert ist durch

   $$l(p) = \max \{b \in B \mid (b, p) \in E\},$$

   - f(p), $p \in P$, definiert ist durch

   $$f(p) = \min \{b \in B \mid (b, p) \in E\},$$

   bei dem sukzessive die Bauelemente in einer Reihenfolge, die durch die Bauelementtypen-Ordnung gegeben ist, den Pipettenarten auf folgende Weise zugeordnet werden:

   existieren für einen Bauelementtypen Pipettenarten, denen nicht ein beliebiges Vielfaches der Zyklenzahl z viele Bauelemente bereits zugeordnet sind, so werden zunächst diese Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;
   verbleiben dann noch Bauelemente dieses Bauelementtyps, so werden diese der gemäß der Pipettenarten-Ordnung letzten möglichen Pipettenart zugeordnet, und
   bei dem aus der Anzahl der einer Pipettenart zugeordneten Bauelemente eine Anzahl von Pipetten, die von der Pipettenart auszuwählen sind, ermittelt wird.

2. Verfahren zur rechnergestützten Pipettenauswahl für einen Bestückungskopf eines Bestückungsautomaten und zur Zuordnung von Bauelementen zu den in einer Pipettenauswahl vorgegebenen Pipettenarten bei einer vorgegebenen Zyklenzahl z, bei dem unter Verwendung

- einer gespeicherten Bauelementtypen-Liste B mit jeweils zugehöriger Anzahl zu setzender Bauelemente des Bauelementtyps,
- einer gespeicherten Pipettenarten-Liste P von zur Verfügung stehenden Pipettenarten und einer Zuordnungsliste E, die angibt, welche Bauelementtypen mit welchen Pipettenarten gesetzt werden können,

überprüft wird, ob eine zulässige Bauelementtypen-Ordnung existiert, d.h., ob gilt:

$$(b1, p) \in E, (b2, p) \in E, b1 \leq b \leq b2 \Rightarrow (b, p) \in E,$$

wobei mit

-- b1, b2, b Bauelemente der Bauelementtypen-Liste B bezeichnet werden,
-- (b, p) ∈ E, b ∈ B, p ∈ P, den Fall bezeichnet, daß ein Bauelement vom Bauelementtypen b mit einer Pipette der Pipettenart p gesetzt werden kann,

bei dem ausgehend von der zulässigen Bauelementtypen-Ordnung für die Pipettenarten p ∈ P eine Pipettenarten-Ordnung gebildet wird, derart, daß gilt:

$$p_1 \leq p_2 \Rightarrow (l(p_1)<l(p_2)) \vee ((l(p_1)=l(p_2)) \wedge f(p_1)\geq f(p_2))),$$

wobei

- p1, p2 ∈ P unterschiedliche Pipettenarten bezeichnen,
- l(p), p ∈ P, definiert ist durch

$$l(p) = \max (b \in B \mid (b, p) \in E\},$$

- f (p) , p ∈ P, definiert ist durch

$$f(p) = \min \{b \in B \mid (b, p) \in E),$$

bei dem sukzessive die Bauelemente in einer Reihenfolge, die durch die Bauelementtypen-Ordnung gegeben ist, den Pipettenarten auf folgende Weise zugeordnet werden:

existieren für einen Bauelementtypen Pipettenarten, denen nicht ein beliebiges Vielfaches der Zyklenzahl z viele Bauelemente bereits zugeordnet sind, so werden zunächst diese Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;
verbleiben dann noch Bauelemente dieses Bauelementtyps, so werden diese der gemäß der Pipettenarten-Ordnung letzten möglichen Pipettenart zugeordnet, und
bei dem aus der Anzahl der einer Pipettenart zugeordneten Bauelemente eine Anzahl von Pipetten, die von der Pipettenart auszuwählen sind, ermittelt wird.

**3.** Verfahren nach Anspruch 2,

- bei dem für den Fall, daß die zulässige Bauelementtypen-Ordnung nicht existiert, die Zuordnungsliste E verkleinert wird: ausgehend von den Bauelementtypen und den Pipettenarten sukzessive für jede Pipettenart so viele Bauelemente wie möglich der jeweiligen Pipettenart zugeordnet werden, so daß zur resultierenden Zuordnungsliste E eine Bauelementtypen-Ordnung auf den Bauelementtypen existiert derart, daß gilt:

$$(b1, p) \in E, (b2, p) \in E, b1 \leq b \leq b2 \Rightarrow (b, p) \in E,$$

- bei dem für die Pipettenarten p ∈ P eine Pipettenarten-Ordnung gebildet wird derart, daß gilt:

$$p_1 \leq p_2 \Rightarrow (l(p_1)<l(p_2)) \vee ((l(p_1)=l(p_2)) \wedge f(p_1) \geq f(p_2))),$$

- bei dem sukzessive die Bauelemente in einer Reihenfolge, die durch die Bauelementtypen-Ordnung gegeben ist, den Pipettenarten auf folgende Weise zugeordnet werden: existieren für einen Bauelementtypen Pipettenarten, denen nicht ein beliebiges Vielfaches der Zyklenzahl z viele Bauelemente bereits zugeordnet sind, so werden zunächst diese Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;
  verbleiben dann noch Bauelemente dieses Bauelementtyps, so werden diese der gemäß der Pipettenarten-Ordnung letzten möglichen Pipettenart zugeordnet, und
- bei dem aus der Anzahl der einer Pipettenart zugeordneten Bauelemente eine Anzahl von Pipetten, die von der Pipettenart auszuwählen sind, ermittelt wird.

**4.** Verfahren nach Anspruch 2,
bei dem für den Fall, daß die zulässige Bauelementtypen-Ordnung nicht existiert, die zu ermittelnde Lösung durch Lösung einer Folge von Flußproblemen bestimmt wird.

**5.** Verfahren nach Anspruch 2,

- bei dem für den Fall, daß die zulässige Bauelementtypen-Ordnung nicht existiert, geprüft wird, ob für mögliche Zuordnungen der Bauelementtypen zu den Pipettenarten gemäß der Zuordnungsliste E eine Menge von Bäumen mit den Pipettenarten als Knoten der Bäume ermittelt werden kann, so daß jeder von einer Menge von Pipettenarten P(b), die ein Bauelement b setzen können, induzierte Teilgraph der Menge der Bäume zusammenhängend ist,
- bei dem, wenn eine solche Menge von Bäumen ermittelt werden kann, die zu ermittelnde Lösung durch Lösung einer Folge von Flußproblemen bestimmt wird.

**6.** Verfahren nach Anspruch 2,

- bei dem für den Fall, daß die zulässige Ordnung nicht existiert, geprüft wird, ob für mögliche Zuordnungen der Bauelementtypen zu den Pipettenarten gemäß der Zuordnungsliste eine Menge von Bäumen mit den Pipettenarten als Knoten der Bäume ermittelt werden kann, so daß jeder von einer Menge von Pipettenarten P(b), die ein Bauelement b setzen können, induzierte Teilgraph der Menge der Bäume zusammenhängend ist,
- bei dem, wenn eine solche Menge von Bäumen nicht ermittelt werden kann, Elemente aus der Zuordnungsliste E gelöscht werden, bis eine solche Menge von Bäumen ermittelt werden kann, und
- bei dem die zu ermittelnde Lösung durch Lösung einer Folge von Flußproblemen bestimmt wird.

**7.** Verfahren nach einem der Ansprüche 4 bis 6,
bei dem die Folge von Flußproblemen gemäß folgender Vorschriften gebildet wird:

$$\sum_{p:(b,p)\in E} x_{bp} = n_b \qquad \forall\ b \in B$$

$$\sum_{p:(b,p)\in E} x_{bp} \leq c_p \qquad \forall\ p \in P$$

wobei

- $n_b$ eine Zahl der zu setzenden Bauelemente vom Bauelementtypen $b \in E$ angibt,
- $c_p$, $p \in P$ eine vorgebbare Schranke, durch deren Variation die Folge von Flußproblemen gebildet wird, bezeichnet wird,
- eine erste Lösungsvariable $x_{bp}$ angibt, wie viele Bauelemente vom Bauelementtypen $b \in B$ durch eine Pipette der Pipettenart $p \in P$ gesetzt werden.

**8.** Verfahren nach Anspruch 2,

- bei dem für den Fall, daß die zulässige Ordnung nicht existiert, geprüft wird, ob für mögliche Zuordnungen der Bauelementtypen zu den Pipettenarten gemäß der Zuordnungsliste eine Menge von Bäumen mit den Pipettenarten als Knoten der Bäume ermittelt werden kann, so daß jeder von einer Menge von Pipettenarten P(b), die ein Bauelement b setzen können, induzierte Teilgraph der Menge der Bäume zusammenhängend ist.
- bei dem, wenn eine solche Menge von Bäumen nicht ermittelt werden kann, die zu ermittelnde Lösung durch Lösen eines linearen Programms ermittelt wird.

**9.** Verfahren nach Anspruch 8,
bei dem das lineare Programm gemäß folgender Vorschriften gebildet wird:

$$\sum_{p:(b,p)\in E} x_{bp} = n_b \qquad \forall\ b \in B$$

$$\sum_{p:(b,p)\in E} x_{bp} \leq y_p \cdot z \qquad \forall\ p \in P$$

$$\sum_{p\in P} y_p \leq k$$

wobei

- $n_b$ eine Zahl der zu setzenden Bauelemente vom Bauelementtypen $b \in E$ angibt,
- eine erste Lösungsvariable $x_{bp}$ angibt, wie viele Bauelemente vom Bauelementtypen $b \in B$ durch eine Pipette des Pipettenart $p \in P$ gesetzt werden,
- eine zweite Lösungsvariable yp angibt, wie viele Pipetten der Pipettenart $p \in P$ ausgewählt werden,
- k eine Zahl von Segmenten des Bestückungskopfs bezeichnet,
- x, y $\geq$ ganzzahlig ist.

**10.** Verfahren nach Anspruch 9,
bei dem das lineare Programm unter Verwendung eines Branchand-Cut-Verfahrens gelöst wird.

**11.** Verfahren nach einem des Ansprüche 1 bis 10,
das mehrmals für jeweils eine unterschiedliche Zyklenzahl durchgeführt wird.

**12.** Verfahren nach einem der Ansprüche 1 bis 11,
bei dem die ermittelten Pipetten dem Bestückungskopf zugeordnet werden und die Bauelemente mit dem Bestükkungskopf auf eine Leiterplatte gesetzt werden.

**13.** Vorrichtung zur rechnergestützten Pipettenauswahl für einen Bestückungskopf eines Bestückungsautomaten und zur Zuordnung von Bauelementen zu den in einer Pipettenauswahl vorgegebenen Pipettenarten bei einer vorgegebenen Zyklenzahl z,

- mit einem Speicher zur Speicherung einer Bauelementtypen-Liste B, einer Pipettenarten-Liste P, und einer

Zuordnungsliste E,
- mit einer mit dem Speicher gekoppelten Prozessor, der derart eingerichtet ist, daß folgende Schritte durchführbar sind:

  unter Verwendung

- der gespeicherten Bauelementtypen-Liste B mit jeweils zugehöriger Anzahl zu setzender Bauelemente des Bauelementtyps,
- einer Bauelementtypen-Ordnung auf den Bauelementtypen,
- der gespeicherten Pipettenarten-Liste P von zur Verfügung stehenden Pipettenarten und der Zuordnungsliste E, die angibt, welche Bauelementtypen mit welchen Pipettenarten gesetzt werden können,

wird ausgehend von der Bauelementtypen-Ordnung für die Pipettenarten $p \in P$ eine Pipettenarten-Ordnung gebildet, derart, daß gilt:

$$p_1 \leq p_2 \Rightarrow (l(p_1)<1(p_2)) \vee ((l(p_1)=l(p_2)) \wedge f(p_1)\geq f(p_2))),$$

wobei

- $p1, p2 \in P$ unterschiedliche Pipettenarten bezeichnen,
- $l(p)$, $p \in P$, definiert ist durch

$$l(p) = \max \{b \in B \mid (b, p) \in E\},$$

- $f(p)$, $p \in P$, definiert ist durch

$$f(p) = \min \{b \in B \mid (b, p) \in E\},$$

bei dem sukzessive die Bauelemente in einer Reihenfolge, die durch die Bauelementtypen-Ordnung gegeben ist, den Pipettenarten auf folgende Weise zugeordnet werden:

existieren für einen Bauelementtypen Pipettenarten, denen nicht ein beliebiges Vielfaches der Zyklenzahl z viele Bauelemente bereits zugeordnet sind, so werden zunächst diese Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;
verbleiben dann noch Bauelemente dieses Bauelementtyps, so werden diese der gemäß der Pipettenarten-Ordnung letzten möglichen Pipettenart zugeordnet, und
bei dem aus der Anzahl der einer Pipettenart zugeordneten Bauelemente eine Anzahl von Pipetten, die von der Pipettenart auszuwählen sind, ermittelt wird.

**14.** Vorrichtung zur rechnergestützten Pipettenauswahl für einen Bestückungskopf eines Bestückungsautomaten und zur Zuordnung von Bauelementen zu den in einer Pipettenauswahl vorgegebenen Pipettenarten bei einer vorgegebenen Zyklenzahl z,

- mit einem Speicher zur Speicherung einer Bauelementtypen-Liste B, einer Pipettenarten-Liste P, und einer Zuordnungsliste E,
- mit einer mit dem Speicher gekoppelten Prozessor, der derart eingerichtet ist, daß folgende Schritte durchführbar sind:

  unter Verwendung

- einer gespeicherten Bauelementtypen-Liste B mit jeweils zugehöriger Anzahl zu setzender Bauelemente des Bauelementtyps,
- einer gespeicherten Pipettenarten-Liste P von zur Verfügung stehenden Pipettenarten und einer Zuordnungsliste E, die angibt, welche Bauelementtypen mit welchen Pipettenarten gesetzt werden können,

wird überprüft, ob eine zulässige Bauelementtypen-Ordnung existiert, d.h., ob gilt:

$$(b1, p) \in E, (b2, p) \in E, b1 \leq b \leq b2 \Rightarrow (b, p) \in E,$$

wobei mit

-- b1, b2, b Bauelemente der Bauelementtypen-Liste B bezeichnet werden,
-- (b, p) ∈ E, b ∈ B, p ∈ P, den Fall bezeichnet, daß ein Bauelement vom Bauelementtypen b mit einer Pipette der Pipettenart p gesetzt werden kann,

bei dem ausgehend von der zulässigen Bauelementtypen-Ordnung für die Pipettenarten p ∈ P eine Pipettenarten-Ordnung gebildet wird, derart, daß gilt:

$$p_1 \leq p_2 \Rightarrow (l(p_1)<l(p_2)) \vee ((l(p_1)=l(p_2)) \wedge f(p_1)\geq(p_2))),$$

wobei

- p1, p2 ∈ P unterschiedliche Pipettenarten bezeichnen,
- l(p), p ∈ P, definiert ist durch

$$l(p) = \max \{b \in B \mid (b, p) \in E\},$$

- f(p), p ∈ P, definiert ist durch

$$f(p) = \min \{b \in B \mid (b, p) \in E\},$$

bei dem sukzessive die Bauelemente in einer Reihenfolge, die durch die Bauelementtypen-Ordnung gegeben ist, den Pipettenarten auf folgende Weise zugeordnet werden:

existieren für einen Bauelementtypen Pipettenarten, denen nicht ein beliebiges Vielfaches der Zyklenzahl z viele Bauelemente bereits zugeordnet sind, so werden zunächst diese Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;
verbleiben dann noch Bauelemente dieses Bauelementtyps, so werden diese der gemäß der Pipettenarten-Ordnung letzten möglichen Pipettenart zugeordnet, und
bei dem aus der Anzahl der einer Pipettenart zugeordneten Bauelemente eine Anzahl von Pipetten, die von der Pipettenart auszuwählen sind, ermittelt wird.

**15.** Vorrichtung nach Anspruch 14, bei der der Prozessor derart eingerichtet ist, daß

- für den Fall, daß die zulässige Bauelementtypen-Ordnung nicht existiert, wird die Zuordnungsliste E verkleinert: ausgehend von den Bauelementtypen und den Pipettenarten sukzessive für jede Pipettenart so viele Bauelemente wie möglich der jeweiligen Pipettenart zugeordnet werden, so daß zur resultierenden Zuordnungsliste E eine Bauelementtypen-Ordnung auf den Bauelementtypen existiert derart, daß gilt:

$$(b1, p) \in E, (b2, p) \in E, b1 \leq b \leq b2 \Rightarrow (b, p) \in E,$$

- für die Pipettenarten p ∈ P eine Pipettenarten-Ordnung gebildet wird derart, daß gilt:

$$p_1 \leq p_2 \Rightarrow (l(p_1)<l(p_2)) \vee ((l(p_1)=l(p_2)) \wedge f(p_1)\geq f(p_2))),$$

- sukzessive die Bauelemente in einer Reihenfolge, die durch die Bauelementtypen-Ordnung gegeben ist, den

Pipettenarten auf folgende Weise zugeordnet werden:

existieren für einen Bauelementtypen Pipettenarten, denen nicht ein beliebiges Vielfaches der Zyklenzahl z viele Bauelemente bereits zugeordnet sind, so werden zunächst diese Pipettenarten gemäß der Pipettenarten-Ordnung Bauelemente zugeordnet in der Art, daß die Zahl der zugeordneten Bauelemente soweit möglich auf das nächste Vielfache der Zyklenzahl z ergänzt wird;
verbleiben dann noch Bauelemente dieses Bauelementtyps, so werden diese der gemäß der Pipettenarten-Ordnung letzten möglichen Pipettenart zugeordnet, und

- aus der Anzahl der einer Pipettenart zugeordneten Bauelemente eine Anzahl von Pipetten, die von der Pipettenart auszuwählen sind, ermittelt wird.

**16.** Vorrichtung nach Anspruch 14,
bei der die Prozessor derart eingerichtet ist, daß für den Fall, daß die zulässige Bauelementtypen-Ordnung nicht existiert, die zu ermittelnde Lösung durch Lösung einer Folge von Flußproblemen bestimmt wird.

**17.** Vorrichtung nach Anspruch 14, bei der die Prozessor derart eingerichtet ist, daß

- für den Fall, daß die zulässige Bauelementtypen-Ordnung nicht existiert, geprüft wird, ob für mögliche Zuordnungen der Bauelementtypen zu den Pipettenarten gemäß der Zuordnungsliste E eine Menge von Bäumen mit den Pipettenarten als Knoten der Bäume ermittelt werden kann, so daß jeder von einer Menge von Pipettenarten P(b), die ein Bauelement b setzen können, induzierte Teilgraph der Menge der Bäume zusammenhängend ist,
- wenn eine solche Menge von Bäumen ermittelt werden kann, die zu ermittelnde Lösung durch Lösung einer Folge von Flußproblemen bestimmt wird.

**18.** Vorrichtung nach Anspruch 14, bei der die Prozessor derart eingerichtet ist, daß

- für den Fall, daß die zulässige Ordnung nicht existiert, geprüft wird, ob für mögliche Zuordnungen der Bauelementtypen zu den Pipettenarten gemäß der Zuordnungsliste eine Menge von Bäumen mit den Pipettenarten als Knoten der Bäume ermittelt werden kann, so daß jeder von einer Menge von Pipettenarten P(b), die ein Bauelement b setzen können, induzierte Teilgraph der Menge der Bäume zusammenhängend ist,
- wenn eine solche Menge von Bäumen nicht ermittelt werden kann, Elemente aus der Zuordnungsliste E gelöscht werden, bis eine solche Menge von Bäumen ermittelt werden kann, und
- bei dem die zu ermittelnde Lösung durch Lösung einer Folge von Flußproblemen bestimmt wird,

**19.** Vorrichtung nach einem der Ansprüche 16 bis 18, bei der die Prozessor derart eingerichtet ist, daß die Folge von Flußproblemen gemäß folgender Vorschriften gebildet wird:

$$\sum_{p:(b,p)\in E} x_{bp} = n_b \quad . \quad \forall\ b \in B$$

$$\sum_{p:(b,p)\in E} x_{bp} \leq c_p \quad \forall\ p \in P \quad .$$

wobei

- $n_b$ eine Zahl der zu setzenden Bauelemente vom Bauelementtypen $b \in E$ angibt,
- $c_p$, $p \in P$, eine vorgebbare Schranke, durch deren Variation die Folge von Flußproblemen gebildet wird, bezeichnet wird,
- eine erste Lösungsvariable $x_{bp}$ angibt, wie viele Bauelemente vom Bauelementtypen $b \in B$ durch eine Pipette

der Pipettenart $p \in P$ gesetzt werden.

**20.** Vorrichtung nach Anspruch 14, bei der die Prozessor derart eingerichtet ist, daß

- für den Fall, daß die zulässige Ordnung nicht existiert, geprüft wird, ob für mögliche Zuordnungen der Bauelementtypen zu den Pipettenarten gemäß der Zuordnungsliste eine Menge von Bäumen mit den Pipettenarteh als Knoten der Bäume ermittelt werden kann, so daß jeder von einer Menge von Pipettenarten P(b), die ein Bauelement b setzen können, induzierte Teilgraph der Menge der Bäume zusammenhängend ist.
- wenn eine solche Menge von Bäumen nicht ermittelt werden kann, die zu ermittelnde Lösung durch Lösen eines linearen Programms ermittelt wird, als das die möglichen Zuordnungen formuliert werden.

**21.** Vorrichtung nach Anspruch 14,
bei der die Prozessor derart eingerichtet ist, daß das lineare Programm gemäß folgender Vorschriften gebildet wird:

$$\sum_{p:(b,p)\in E} x_{bp} = n_b \qquad \forall\ b \in B$$

$$\sum_{p:(b,p)\in E} x_{bp} \leq y_p \cdot z \qquad \forall\ p \in P$$

$$\sum_{p\in P} y_p \leq k$$

wobei

- $n_b$ eine Zahl der zu setzenden Bauelemente vom Bauelementtypen $b \in E$ angibt,
- eine erste Lösungsvariable $x_{bp}$ angibt, wie viele Bauelemente vom Bauelementtypen $b \in E$ durch eine Pipette der Pipettenart $p \in P$ gesetzt werden,
- eine zweite Lösungsvariable yp angibt, wie viele Pipetten der Pipettenart $p \in P$ ausgewählt werden,
- k eine Zahl von Segmenten des Bestückungskopfs bezeichnet,
- $x, y \geq 0$, ganzzahlig ist.

**22.** Vorrichtung nach Anspruch 21,
bei der die Prozessor derart eingerichtet ist, daß das lineare Programm unter Verwendung eines Branch-and-Cut-Verfahrens gelöst wird.

**23.** Vorrichtung nach einem der Ansprüche 13 bis 22,
bei der die Prozessor derart eingerichtet ist, daß das Verfahren mehrmals für jeweils eine unterschiedliche Zyklenzahl durchgeführt wird.

**24.** Bestückungsautomat mit einer Vorrichtung nach einem der Ansprüche 13 bis 23,
mit einem Bauelementespeicher für die Bauelemente,
mit einem Bestückungskopf zur Aufnahme von Pipetten,
mit mindestens einer Pipette zur Aufnahme der Bauelemente,
mit einer Bestückungseinrichtung zum Bestücken der Bauelemente auf einer Leiterplatte.

## Claims

1. Method for computer-aided pipette selection for a placement head of an automatic placement machine and for allocation of components to the pipette types predetermined in a pipette selection for a given number of cycles z, in which, using

   - a stored component type list B with a respectively associated number of components of the component type to be placed,
   - a component type association based on the component types,
   - a stored pipette type list P of available pipette types and an allocation list E which indicates which component types can be placed using what pipette types,

   and based on the component type association for the pipette types $p \in P$, a pipette type association is formed in such a manner that:

   $$p1 \leq p2 \Rightarrow (1(p1)<1(p2)) \vee ((1(p1)=1(p2)) \wedge f(p1) \geq f(p2))),$$

   where

   - $p1, p2 \in P$ denote different pipette types,
   - $l(p), p \in P$, is defined by

   $$l(p) = \max \{b \in B \mid (b, p) \in E\},$$

   - $f(p), p \in P$, is defined by

   $$f(p) = \min \{b \in B \mid (b, p) \in E\},$$

   in which the components are successively allocated to the pipette types, in a sequence which results from the component type association, in the following manner:

   if, for a component type, pipette types exist to which any given multiple of the number of cycles z of large numbers of components are not already allocated, then these pipette types are first of all allocated to components on the basis of the pipette type association, in such a manner that the number of allocated components is rounded up where possible to the next multiple of the number of cycles z;
   if any components of this component type remain, then these are allocated to the last possible pipette type based on the pipette type association and,

   in which the number of components allocated to one pipette type is used to determine the number of pipettes of that pipette type to be selected.

2. Method for computer-aided pipette selection for a placement head of an automatic placement machine and for allocation of components to the pipette types predetermined in a pipette selection for a given number of cycles z, in which, using

   - a stored component type list B with a respectively associated number of components of the component type to be placed,
   - a stored pipette type list P of available pipette types and an allocation list E which indicates which component types can be placed using what pipette types,

   a check is carried out to determine whether a permissible component type association exists, that is to say whether:

   $$(b1, p) \in E, (b2, p) \in E, b1 \leq b \leq b2 \Rightarrow (b, p) \in E,$$

where

- -- b1, b2, b components in the component type list B are denoted,
- -- (b, p) ∈ E, b ∈ B, p ∈ P, denotes the situation

where a component of component type b can be placed using a pipette of pipette type p, in which, based on the permissible component type association for the pipette types p ∈ P, a pipette type association is formed in such a manner that:

$$p1 \leq p2 \Rightarrow (1(p1)<1(p2)) \vee ((1(p1)=1(p2)) \wedge f(p1)\geq f(p2))),$$

where

- p1, p2 ∈ P denote different pipette types,
- 1(p), p ∈ P, is defined by

$$1(p) = \max \{b \in B \mid (b, p) \in E\},$$

- f(p), p ∈ P, is defined by

$$f(p) = \min \{b \in B \mid (b, p) \in E\},$$

in which the components are successively allocated to the pipette types, in a sequence which results from the component type association, in the following manner:

if, for a component type, pipette types exist to which any given multiple of the number of cycles z of large numbers of components are not already allocated, then these pipette types are first of all allocated to components on the basis of the pipette type association, in such a manner that the number of allocated components is rounded up where possible to the next multiple of the number of cycles z;
if any components of this component type remain, then these are allocated to the last possible pipette type based on the pipette type association and,

in which the number of components allocated to one pipette type is used to determine the number of pipettes of that pipette type to be selected.

**3.** Method according to Claim 2,
in which, in the situation where no permissible component type association exists, the allocation list E is reduced in size: based on the component types and the pipette types, as many components as possible are allocated successively for each pipette type to the respective pipette type so that a component type association to the component types exists for the resultant allocation list E in such a manner that:

$$(b1, p) \in E, (b2, p) \in E, b1 \leq b \leq b2 \Rightarrow (b, p) \in E,$$

- in which, for the pipette types p ∈ P a pipette type association is formed in such a manner that:

$$P1 \leq P2 \Rightarrow (1(P1) < 1(P2)) \wedge ((1(P1) = 1(P2)) \wedge f(P1)\geq f(P2))),$$

- in which the components are successively allocated to the pipette types, in a sequence which results from the component type association, in the following manner:

if, for a component type, pipette types exist to which any given multiple of the number of cycles z of large numbers of components are not already allocated, then these pipette types are first of all allocated to components on the basis of the pipette type association, in such a manner that the number of allocated

components is rounded up where possible to the next multiple of the number of cycles z;

- if any components of this component type remain, then these are allocated to the last possible pipette type based on the pipette type association and,

in which the number of components allocated to one pipette type is used to determine the number of pipettes of that pipette type to be selected.

**4.** Method according to Claim 2,
in which, in the situation where no permissible component type association exists, the solution to be determined is found by solving a sequence of flow problems.

**5.** Method according to Claim 2,

- in which, in the situation where no permissible component type association exists, a check is carried out to determine whether a set of trees with the pipette types as nodes of the trees can be determined for possible allocations of the component types to the pipette types in accordance with the allocation list E, so that each sub-graph, which is induced from a set of pipette types P(b) which can place a component b, in the set of trees is cohesive, and
- in which, if such a set of trees can be determined, the solution to be determined is found by solving a sequence of flow problems.

**6.** Method according to Claim 2,

- in which, in the situation where no permissible association exists, a check is carried out to determine whether a set of trees with the pipette types as nodes of the trees can be determined for possible allocations of the component types to the pipette types in accordance with the allocation list, so that each sub-graph, which is induced by a set of pipette types P(b) which can place a component b, in the set of trees is cohesive,
- in which, if such a set of trees cannot be determined, elements are deleted from the allocation list E until such a set of trees can be determined, and
- in which the solution to be determined is found by solving a sequence of flow problems.

**7.** Method according to one of Claims 4 to 6,
in which the sequence of flow problems is formed in accordance with the following rules:

$$\sum_{p:(b,p)\in E} x_{bp} = n_b \qquad \forall\ b \in B$$

$$\sum_{p:(b,p)\in E} x_{bp} \leq c_p \qquad \forall\ p \in P$$

where

- $n_b$ indicates a number of components of the component type $b \in E$ to be placed,
- $c_p$, $p \in P$ denotes a window which can be predetermined and which is varied in association to form the sequence of flow problems,
- a first solution variable $x_{bp}$ indicates how many components of the component type $b \in B$ are placed by a pipette of the pipette type $p \in P$.

**8.** Method according to Claim 2,

- in which, in the situation where no permissible association exists, a check is carried out to determine whether a set of trees with the pipette types as nodes of the trees can be determined for possible allocations of the component types to the pipette types in accordance with the allocation list, so that each sub-graph, which is induced by a set of pipette types P(b) which can place a component b, in the set of trees is cohesive, and
- in which, if no such set of trees can be determined, the solution to be determined is found by solving a linear program.

**9.** Method according to Claim 8,
in which the linear program is formed in accordance with the following rules:

$$\sum_{p:(b,p)\in E} x_{bp} = n_b \qquad \forall\ b \in B$$

$$\sum_{p:(b,p)\in E} x_{bp} \leq y_p \cdot z \qquad \forall\ p \in P$$

$$\sum_{p\in P} y_p \leq k$$

where

- $n_b$ indicates a number of components of the component type b ∈ E to be placed,
- a first solution variable $x_{bp}$ indicates how many components of the component type b ∈ B are placed by a pipette of the pipette type p ∈ P,
- a second solution variable yp indicates how many pipettes of the pipette type p ∈ P are selected,
- k denotes a number of segments of the placement head, and
- x,y ≥ 0 is an integer.

**10.** Method according to Claim 9,
in which the linear program is solved using a branch and cut method.

**11.** Method according to one of Claims 1 to 10,
which is carried out a number of times for a different number of cycles in each case.

**12.** Method according to one of Claims 1 to 11,
in which the pipettes which have been determined are allocated to the placement head, and the components are placed on a printed circuit board using the placement head.

**13.** Apparatus for computer-aided pipette selection for a placement head of an automatic placement machine and for allocation of components to the pipette types predetermined in a pipette selection for a given number of cycles z,

- having a memory for storing a component type list B, a pipette type list B and an allocation list E,
- having a processor which is coupled to the memory and is set up in such a manner that the following steps can be carried out:

  using

- the stored component type list B with the respectively associated number of components of the component type to be placed,
- a component type association for the component types,
- the stored pipette type list P of available pipette types and the allocation list E which indicates which component types can be placed by what pipette types,

and based on the component type association for the pipette types $p \in P$, a pipette type association is formed in such a manner that:

$$p1 \leq p2 \Rightarrow (1(p1)<1(p2)) \vee ((1(p1)=1(p2)) \wedge f(p1)>f(p2))),$$

where

- $p1, p2 \in P$ denote different pipette types,
- $1(p), p \in P$, is defined by

$$1(p) = \max \{b \in B \mid (b, p) \in E\},$$

- $f(p), p \in P$, is defined by

$$f(p) = \min \{b \in B \mid (b, p) \in E\},$$

in which the components are successively allocated to the pipette types, in a sequence which results from the component type association, in the following manner:

if, for a component type, pipette types exist to which any given multiple of the number of cycles z of large numbers of components are not already allocated, then these pipette types are first of all allocated to components on the basis of the pipette type association, in such a manner that the number of allocated components is rounded up where possible to the next multiple of the number of cycles z;
if any components of this component type remain, then these are allocated to the last possible pipette type based on the pipette type association and,

in which the number of components allocated to one pipette type is used to determine the number of pipettes of that pipette type to be selected.

**14.** Apparatus for computer-aided pipette selection for a placement head of an automatic placement machine and for allocation of components to the pipette types predetermined in a pipette selection for a given number of cycles z,

- having a memory for storing a component type list B, a pipette type list B and an allocation list E,
- having a processor which is coupled to the memory and is set up in such a manner that the following steps can be carried out:

using

- a stored component type list B with the respectively associated number of components of the component type to be placed,
- a stored pipette type list P of available pipette types and an allocation list E which indicates which component types can be placed by what pipette types,

a check is carried out to determine whether a permissible component type association exists, that is to say whether:

$$(b1, p) \in E, (b2, p) \in E, b1 \leq b \leq b2 \Rightarrow (b, p) \in E,$$

where

- -- b1, b2, b components in the component type list B are denoted,
- -- (b, p) ∈ E, b ∈ B, p ∈ P, denotes the situation

where a component of component type b can be placed using a pipette of pipette type p, in which, based on the permissible component type association for the pipette types p ∈ P, a pipette type association is formed in such a manner that:

$$p1 \leq p2 \Rightarrow (1(p1)<1(p2)) \vee ((1(p1)=1(p2)) \wedge f(p1) \geq f(p2))),$$

where

- p1, p2 ∈ P denote different pipette types,
- 1(p), p ∈ P, is defined by

$$1(p) = \max \{b \in B \mid (b, p) \in E\},$$

- f(p), p ∈ P, is defined by

$$f(p) = \min \{b \in B \mid (b, p) \in E\},$$

in which the components are successively allocated to the pipette types, in a sequence which results from the component type association, in the following manner:

if, for a component type, pipette types exist to which any given multiple of the number of cycles z of large numbers of components are not already allocated, then these pipette types are first of all allocated to components on the basis of the pipette type association, in such a manner that the number of allocated components is rounded up where possible to the next multiple of the number of cycles z;
if any components of this component type remain, then these are allocated to the last possible pipette type based on the pipette type association and,

in which the number of components allocated to one pipette type is used to determine the number of pipettes of that pipette type to be selected.

**15.** Apparatus according to Claim 14,
in which the processor is set up in such a manner that

- in the situation where no permissible component type association exists, the allocation list E is reduced in size: based on the component types and the pipette types, as many components as possible are allocated successively for each pipette type to the respective pipette type so that a component type association to the component types exists for the resultant allocation list E in such a manner that:

$$(b1, p) \in E, (b2, p) \in E, b1 \leq b \leq b2 \Rightarrow (b, p) \in E,$$

- in which, for the pipette types p ∈ P a pipette type association is formed in such a manner that:

$$P1 \leq P2 \Rightarrow (1(P1) < 1(P2)) \vee ((1(P1) = 1(P2)) \wedge f(P1) \geq f(P2))),$$

- the components are successively allocated to the pipette types, in a sequence which results from the component type association, in the following manner:

if, for a component type, pipette types exist to which any given multiple of the number of cycles z of large numbers of components are not already allocated, then these pipette types are first of all allocated to components on the basis of the pipette type association, in such a manner that the number of allocated

components is rounded up where possible to the next multiple of the number of cycles z;
if any components of this component type remain, then these are allocated to the last possible pipette type based on the pipette type association and,

- the number of components allocated to one pipette type is used to determine the number of pipettes of that pipette type to be selected.

**16.** Apparatus according to Claim 14,
in which the processor is set up in such a manner that in the situation where no permissible component type association exists, the solution to be determined is found by solving a sequence of flow problems.

**17.** Apparatus according to Claim 14,
in which the processor is set up in such a manner that

- in the situation where no permissible component type association exists, a check is carried out to determine whether a set of trees with the pipette types as nodes of the trees can be determined for possible allocations of the component types to the pipette types in accordance with the allocation list E, so that each sub-graph, which is induced from a set of pipette types P(b) which can place a component b, in the set of trees is cohesive, and
- if such a set of trees can be determined, the solution to be determined is found by solving a sequence of flow problems.

**18.** Apparatus according to Claim 14,
in which the processor is set up in such a manner that

- in the situation where no permissible association exists, a check is carried out to determine whether a set of trees with the pipette types as nodes of the trees can be determined for possible allocations of the component types to the pipette types in accordance with the allocation list, so that each sub-graph, which is induced by a set of pipette types P(b) which can place a component b, in the set of trees is cohesive,
- if such a set of trees cannot be determined, elements are deleted from the allocation list E until such a set of trees can be determined, and
- the solution to be determined is found by solving a sequence of flow problems.

**19.** Apparatus according to one of Claims 16 to 18,
in which the processor is set up in such a manner that the sequence of flow problems is formed in accordance with the following rules:

$$\sum_{p:(b,p)\in E} x_{bp} = n_b \qquad \forall\ b \in B$$

$$\sum_{p:(b,p)\in E} x_{bp} \leq c_p \qquad \forall\ p \in P$$

where

- $n_b$ indicates a number of components of the component type $b \in E$ to be placed,
- $c_p$, $p \in P$ denotes a window which can be predetermined and which is varied in association to form the sequence of flow problems,
- a first solution variable $x_{bp}$ indicates how many components of the component type $b \in B$ are placed by a

pipette of the pipette type $p \in P$.

**20.** Apparatus according to Claim 14, in which the processor is set up in such a manner that

- in the situation where no permissible associatior exists, a check is carried out to determine whether a set of trees with the pipette types as nodes of the trees can be determined for possible allocations of the component types to the pipette types in accordance with the allocation list, so that each sub-graph, which is induced by a set of pipette types P (b) which can place a component b, in the set of trees is cohesive, and
- if such a set of trees cannot be determined, the solution to be determined is found by solving a linear program as the the possible allocations are formulated.

**21.** Apparatus according to Claim 14, in which the processor is set up in such a manner that the linear program is formed in accordance with the following rules:

$$\sum_{p:(b,p)\in E} x_{bp} = n_b \qquad \forall\, b \in B$$

$$\sum_{p:(b,p)\in E} x_{bp} \leq y_p \cdot z \qquad \forall\, p \in P$$

$$\sum_{p\in P} y_p \leq k$$

where

- $n_b$ indicates a number of components of the component type $b \in E$ to be placed,
- a first solution variable $x_{bp}$ indicates how many components of the component type $b \in B$ are placed by a pipette of the pipette type $p \in P$,
- a second solution variable yp indicates how many pipettes of the pipette type $p \in P$ are selected,
- k denotes a number of segments of the placement head, and
- $x,y \geq 0$ is an integer.

**22.** Apparatus according to Claim 21, in which the processor is set up in such a manner that the linear program is solved using a branch and cut method.

**23.** Apparatus according to one of Claims 13 to 22, in which the processor is set up in such a manner that the method is carried out for a different number of cycles in each case.

**24.** Automatic placement machine having an apparatus according to one of Claims 13 to 23,
having a component memory for the component,
having a placement head for picking up pipettes,
having at least one pipette for picking up components,
having a placement device for placing the components on a printed circuit.

## Revendications

**1.** Procédé pour la sélection, assistée par ordinateur, de pipettes pour une tête de mise en place d'une machine automatique de mise en place et pour l'affectation de composants aux types de pipettes prédéfinis dans une sélection de pipettes, pour un nombre de cycles z prédéfini, dans lequel, en utilisant

- une liste B de types de composants mémorisée, contenant à chaque fois le nombre correspondant de composants du type de composant à mettre en place,
- une suite de types de composants appliquée aux types de composants,
- une liste P de types de pipettes mémorisée contenant les types de pipettes disponibles et une liste d'affectation E indiquant quels types de composants peuvent être mis en place avec quels types de pipettes,

on forme pour les types de pipettes $p \in P$, à partir de la suite de types de composants, une suite de types de pipettes de manière à ce que la formule

$$p1 \leq p2 \Rightarrow (l(p1) < l(p2)) \vee ((l(p1)=l(p2)) \wedge f(p1) \geq f(p2)))$$

soit vérifiée,
avec

- p1, p2 $\in$ P désignant différents types de pipettes,
- l(p), $p \in P$ étant défini par

$$l(p) = \max \{b \in B \mid (b, p) \in E\},$$

- f(p), $p \in P$ étant défini par

$$f(p) = \min \{b \in B \mid (b, p) \in E\},$$

dans lequel les composants sont successivement affectés aux types de pipettes, de la manière suivante, dans un ordre qui est fixé par la suite de types de composants :

s'il existe, pour un type de composant, des types de pipettes auxquels on n'a pas encore affecté un nombre de composants correspondant à un multiple quelconque du nombre de cycles z, on affecte d'abord des composants à ces types de pipettes, selon la suite de types de pipettes, de manière à ce que le nombre de composants affectés soit complété, dans la mesure du possible, au multiple suivant du nombre de cycles z ;
s'il reste encore des composants de ce type de composant, ils sont affectés au dernier type de pipette possible selon la suite de types de pipettes, et

dans lequel on détermine, à partir du nombre de composants affectés à un type de pipette, un nombre de pipettes devant être sélectionnées dans ce type de pipette.

**2.** Procédé pour la sélection, assistée par ordinateur, de pipettes pour une tête de mise en place d'une machine automatique de mise en place et pour l'affectation de composants aux types de pipettes prédéfinis dans une sélection de pipettes, pour un nombre de cycles z prédéfini, dans lequel, en utilisant

- une liste B de types de composants mémorisée, contenant à chaque fois le nombre correspondant de composants du type de composant à mettre en place,
- une liste P de types de pipettes mémorisée contenant les types de pipettes disponibles et une liste d'affectation E indiquant quels types de composants peuvent être mis en place avec quels types de pipettes,

on vérifie s'il existe une suite de types de composants acceptable, c'est-à-dire si la formule

$$(b1, p) \in E, (b2, p) \in E, b1 \leq b \leq b2 \Rightarrow (b, p) \in E$$

est vérifiée,
avec

- -- b1, b2, b désignant des composants de la liste B de types de composants,
- -- (b, p) ∈ E, b ∈ B, p ∈ P désignant le cas où un composant du type de composant b peut être mis en place avec une pipette du type de pipette p,

dans lequel on forme pour les types de pipettes p ∈ P, à partir de la suite de types de composants acceptable, une suite de types de pipettes de manière à ce que la formule

$$p1 \leq p2 \Rightarrow (l(p1) < l(p2)) \vee ((l(p1)=l(p2)) \wedge f(p1) \geq f(p2)))$$

soit vérifiée,
avec

- p1, p2 ∈ P désignant différents types de pipettes,
- l(p), p ∈ P étant défini par

$$l(p) = \max \{b \in B \mid (b, p) \in E\},$$

- f(p), p ∈ P étant défini par

$$f(p) = \min \{b \in B \mid (b, p) \in E\},$$

dans lequel les composants sont successivement affectés aux types de pipettes, de la manière suivante, dans un ordre qui est fixé par la suite de types de composants :

s'il existe, pour un type de composant, des types de pipettes auxquels on n'a pas encore affecté un nombre de composants correspondant à un multiple quelconque du nombre de cycles z, on affecte d'abord des composants à ces types de pipettes, selon la suite de types de pipettes, de manière à ce que le nombre de composants affectés soit complété, dans la mesure du possible, au multiple suivant du nombre de cycles z ;
s'il reste encore des composants de ce type de composant, ils sont affectés au dernier type de pipette possible selon la suite de types de pipettes, et

dans lequel on détermine, à partir du nombre de composants affectés à un type de pipette, un nombre de pipettes devant être sélectionnées dans ce type de pipette.

**3.** Procédé selon la revendication 2,

- dans lequel, dans le cas où la suite de types de composants acceptable n'existe pas, on réduit la liste d'affectation E : à partir des types de composants et des types de pipettes, on affecte successivement, pour chaque type de pipette, autant de composants que possible au type de pipette respectif, de manière à ce qu'il existe, concernant la liste d'affectation E en résultant, une suite de types de composants appliquée aux types de composants, telle que la formule

$$(b1, p) \in E, (b2, p) \in E, b1 \leq b \leq b2 \Rightarrow (b, p) \in E$$

soit vérifiée,

- dans lequel on forme, pour les types de pipettes p ∈ P, une suite de types de pipettes de manière à ce que la formule

$$p1 \leq p2 \Rightarrow (l(p1) < l(p2) \vee ((l(p1)=l(p2)) \wedge f(p1) \geq f(p2)))$$

soit vérifiée,

- dans lequel les composants sont successivement affectés aux types de pipettes, de la manière suivante, dans un ordre qui est fixé par la suite de types de composants :

  s'il existe, pour un type de composant, des types de pipettes auxquels on n'a pas encore affecté un nombre de composants correspondant à un multiple quelconque du nombre de cycles z, on affecte d'abord des composants à ces types de pipettes, selon la suite de types de pipettes, de manière à ce que le nombre de composants affectés soit complété, dans la mesure du possible, au multiple suivant du nombre de cycles z ;

  s'il reste encore des composants de ce type de composant, ils sont affectés au dernier type de pipette possible selon la suite de types de pipettes, et

- dans lequel on détermine, à partir du nombre de composants affectés à un type de pipette, un nombre de pipettes devant être sélectionnées dans ce type de pipette.

**4.** Procédé selon la revendication 2,
dans lequel, dans le cas où la suite de types de composants acceptable n'existe pas, on détermine la solution à trouver en solutionnant une série de problèmes de flux.

**5.** Procédé selon la revendication 2,

- dans lequel, dans le cas où la suite de types de composants acceptable n'existe pas, on vérifie s'il est possible de déterminer, pour des affectations possibles des types de composants aux types de pipettes selon la liste d'affectation E, un ensemble d'arbres dont les noeuds seraient les types de pipettes, de manière à ce que chaque graphe partiel de l'ensemble d'arbres induit par un ensemble de types de pipettes P(b) pouvant mettre en place un composant b soit continu,
- dans lequel, s'il est possible de déterminer un tel ensemble d'arbres, la solution à trouver est déterminée en solutionnant une série de problèmes de flux.

**6.** Procédé selon la revendication 2,

- dans lequel, dans le cas où la suite acceptable n'existe pas, on vérifie s'il est possible de déterminer, pour des affectations possibles des types de composants aux types de pipettes selon la liste d'affectation, un ensemble d'arbres dont les noeuds seraient les types de pipettes, de manière à ce que chaque graphe partiel de l'ensemble d'arbres induit par un ensemble de types de pipettes P(b) pouvant mettre en place un composant b soit continu,
- dans lequel, s'il n'est pas possible de déterminer un tel ensemble d'arbres, on supprime des éléments de la liste d'affectation E jusqu'à ce qu'il soit possible de déterminer un tel ensemble d'arbres et
- dans lequel la solution à trouver est déterminée en solutionnant une série de problèmes de flux.

**7.** Procédé selon l'une des revendications 4 à 6,
dans lequel la série de problèmes de flux est formée selon les règles suivantes :

$$\sum_{p:(b,p)\in E} x_{bp} = n_b \quad \forall\, b \in B$$

$$\sum_{p:(b,p)\in E} x_{bp} \leq c_p \quad \forall\, p \in P\,,$$

avec

- $n_b$ indiquant un nombre de composants du type de composant $b \in E$ à mettre en place,
- cp, $p \in P$, désignant une limite qui peut être définie par défaut et dont la variation permet de former la série de problèmes de flux,
- une première variable de solution $x_{bp}$ indiquant combien de composants du type de composant $b \in B$ sont mis en place par une pipette du type de pipette $p \in P$.

**8.** Procédé selon la revendication 2,

- dans lequel, dans le cas où la suite acceptable n'existe pas, on vérifie s'il est possible de déterminer, pour des affectations possibles des types de composants aux types de pipettes selon la liste d'affectation, un ensemble d'arbres dont les noeuds seraient les types de pipettes, de manière à ce que chaque graphe partiel de l'ensemble d'arbres induit par un ensemble de types de pipettes P(b) pouvant mettre en place un composant b soit continu,
- dans lequel, s'il n'est pas possible de déterminer un tel ensemble d'arbres, la solution à trouver est déterminée en solutionnant un programme linéaire.

**9.** Procédé selon la revendication 8,
dans lequel le programme linéaire est formé selon les règles suivantes :

$$\sum_{p:(b,p)\in E} x_{bp} = n_b \quad \forall b \in B$$

$$\sum_{p:(b,p)\in E} x_{bp} \leq y_p \cdot z \quad \forall p \in P$$

$$\sum_{p \in P} y_p \leq k \,,$$

avec

- $n_b$ indiquant un nombre de composants du type de composant $b \in E$ à mettre en place,
- une première variable de solution $x_{bp}$ indiquant combien de composants du type de composant $b \in B$ sont mis en place par une pipette du type de pipette $p \in P$,
- une seconde variable de solution yp indiquant combien de pipettes du type de pipette $p \in P$ sont sélectionnées,
- k désignant un nombre de segments de la tête de mise en place,
- x, $y \geq 0$ étant un nombre entier.

**10.** Procédé selon la revendication 9,
dans lequel le programme linéaire est solutionné en utilisant une méthode « branch and cut » (branchement et coupe).

**11.** Procédé selon l'une des revendications 1 à 10,
qui est exécuté plusieurs fois à chaque fois pour un nombre de cycles différent.

**12.** Procédé selon l'une des revendications 1 à 11,
dans lequel les pipettes déterminées sont affectées à la tête de mise en place et les composants sont mis en place sur une carte imprimée à l'aide de la tête de mise en place.

**13.** Dispositif pour la sélection, assistée par ordinateur, de pipettes destinées à une tête de mise en place d'une machine automatique de mise en place et pour l'affectation de composants aux types de pipettes prédéfinis dans une sélection de pipettes, pour un nombre de cycles z prédéfini,

- comprenant une mémoire pour mémoriser une liste B de types de composants, une liste P de types de pipettes et une liste d'affectation E,
- comprenant un processeur couplé à la mémoire et qui est adapté de manière à permettre l'exécution des étapes suivantes :

en utilisant

- la liste B de types de composants mémorisée, contenant à chaque fois le nombre correspondant de composants du type de composant à mettre en place,
- une suite de types de composants appliquée aux types de composants,
- la liste P de types de pipettes mémorisée contenant les types de pipettes disponibles et une liste d'affectation E indiquant quels types de composants peuvent être mis en place avec quels types de pipettes, on forme pour les types de pipettes $p \in P$, à partir de la suite de types de composants, une suite de types de pipettes de manière à ce que la formule

$$p1 \leq p2 \Rightarrow (l(p1) < l(p2)) \vee ((l(p1)=l(p2)) \wedge f(p1) \geq f(p2)))$$

soit vérifiée,
avec

- $p1, p2 \in P$ désignant différents types de pipettes,
- $l(p), p \in P$ étant défini par

$$l(p) = \max \{b \in B \mid (b, p) \in E\},$$

- $f(p), p \in P$ étant défini par

$$f(p) = \min \{b \in B \mid (b, p) \in E\},$$

dans lequel les composants sont successivement affectés aux types de pipettes, de la manière suivante, dans un ordre qui est fixé par la suite de types de composants :

s'il existe, pour un type de composant, des types de pipettes auxquels on n'a pas encore affecté un nombre de composants correspondant à un multiple quelconque du nombre de cycles z, on affecte d'abord des composants à ces types de pipettes, selon la suite de types de pipettes, de manière à ce que le nombre de composants affectés soit complété, dans la mesure du possible, au multiple suivant du nombre de cycles z ;
s'il reste encore des composants de ce type de composant, ils sont affectés au dernier type de pipette possible selon la suite de types de pipettes, et

dans lequel on détermine, à partir du nombre de composants affectés à un type de pipette, un nombre de pipettes devant être sélectionnées dans ce type de pipette.

**14.** Dispositif pour la sélection, assistée par ordinateur, de pipettes destinées à une tête de mise en place d'une machine automatique de mise en place et pour l'affectation de composants aux types de pipettes prédéfinis dans une sélection de pipettes, pour un nombre de cycles z prédéfini,

- comprenant une mémoire pour mémoriser une liste B de types de composants, une liste P de types de pipettes et une liste d'affectation E,
- comprenant un processeur couplé à la mémoire et qui est adapté de manière à permettre l'exécution des étapes suivantes :

en utilisant

- une liste B de types de composants mémorisée, contenant à chaque fois le nombre correspondant de composants du type de composant à mettre en place,
- une liste P de types de pipettes mémorisée contenant les types de pipettes disponibles et une liste d'affectation E indiquant quels types de composants peuvent être mis en place avec quels types de pipettes,

on vérifie s'il existe une suite de types de composants acceptable, c'est-à-dire si la formule

$$(b1, p) \in E, (b2, p) \in E, b1 \leq b \leq b2 \Rightarrow (b, p) \in E$$

est vérifiée,
avec

-- b1, b2, b désignant des composants de la liste B de types de composants,
-- $(b, p) \in E$, $b \in B$, $p \in P$ désignant le cas où un composant du type de composant b peut être mis en place avec une pipette du type de pipette p,

dans lequel on forme pour les types de pipettes $p \in P$, à partir de la suite de types de composants acceptable, une suite de types de pipettes de manière à ce que la formule

$$p1 \leq p2 \Rightarrow (l(p1) < l(p2)) \vee ((l(p1)=l(p2)) \wedge f(p1) \geq f(p2)))$$

soit vérifiée,
avec

- $p1, p2 \in P$ désignant différents types de pipettes,
- $l(p), p \in P$ étant défini par

$$l(p) = \max \{b \in B \mid (b, p) \in E\},$$

- $f(p), p \in P$ étant défini par

$$f(p) = \min \{b \in B \mid (b, p) \in E\},$$

dans lequel les composants sont successivement affectés aux types de pipettes, de la manière suivante, dans un ordre qui est fixé par la suite de types de composants :

s'il existe, pour un type de composant, des types de pipettes auxquels on n'a pas encore affecté un nombre de composants correspondant à un multiple quelconque du nombre de cycles z, on affecte d'abord des composants à ces types de pipettes, selon la suite de types de pipettes, de manière à ce que le nombre de composants affectés soit complété, dans la mesure du possible, au multiple suivant du nombre de cycles z ;
s'il reste encore des composants de ce type de composant, ils sont affectés au dernier type de pipette possible selon la suite de types de pipettes, et

dans lequel on détermine, à partir du nombre de composants affectés à un type de pipette, un nombre de pipettes devant être sélectionnées dans ce type de pipette.

**15.** Dispositif selon la revendication 14,
dans lequel le processeur est adapté de manière à ce que

- dans le cas où la suite de types de composants acceptable n'existe pas, on réduit la liste d'affectation E : à partir des types de composants et des types de pipettes, on affecte successivement, pour chaque type de pipette, autant de composants que possible au type de pipette respectif de manière à ce qu'il existe, concernant la liste d'affectation E en résultant, une suite de types de composants appliquée aux types de composants, telle que la formule

$$(b1, p) \in E, (b2, p) \in E, b1 \leq b \leq b2 \Rightarrow (b, p) \in E$$

soit vérifiée,

- on forme, pour les types de pipettes $p \in P$, une suite de types de pipettes de manière à ce que la formule

$$p1 \leq p2 \Rightarrow (l(p1) < l(p2)) \vee ((l(p1)=l(p2)) \wedge f(p1) \geq f(p2)))$$

soit vérifiée,

- les composants soient successivement affectés aux types de pipettes, de la manière suivante, dans un ordre qui est fixé par la suite de types de composants :

  s'il existe, pour un type de composant, des types de pipettes auxquels on n'a pas encore affecté un nombre de composants correspondant à un multiple quelconque du nombre de cycles z, on affecte d'abord des composants à ces types de pipettes, selon la suite de types de pipettes, de manière à ce que le nombre de composants affectés soit complété, dans la mesure du possible, au multiple suivant du nombre de cycles z ;
  s'il reste encore des composants de ce type de composant, ils sont affectés au dernier type de pipette possible selon la suite de types de pipettes et

- on détermine, à partir du nombre de composants affectés à un type de pipette, un nombre de pipettes devant être sélectionnées dans ce type de pipette.

**16.** Dispositif selon la revendication 14,
dans lequel le processeur est adapté de manière à ce que, dans le cas où la suite de types de composants acceptable n'existe pas, la solution à trouver soit déterminée en solutionnant une série de problèmes de flux.

**17.** Dispositif selon la revendication 14,
dans lequel le processeur est adapté de manière à ce que,

- dans le cas où la suite de types de composants acceptable n'existe pas, on vérifie s'il est possible de déterminer, pour des affectations possibles des types de composants aux types de pipettes selon la liste d'affectation E, un ensemble d'arbres dont les noeuds seraient les types de pipettes, de manière à ce que chaque graphe partiel de l'ensemble d'arbres induit par un ensemble de types de pipettes P(b) pouvant mettre en place un composant b soit continu,
- s'il est possible de déterminer un tel ensemble d'arbres, la solution à trouver soit déterminée en solutionnant une série de problèmes de flux.

**18.** Dispositif selon la revendication 14,
dans lequel le processeur est adapté de manière à ce que,

- dans le cas où la suite acceptable n'existe pas, on vérifie s'il est possible de déterminer, pour des affectations possibles des types de composants aux types de pipettes selon la liste d'affectation, un ensemble d'arbres dont les noeuds seraient les types de pipettes, de manière à ce que chaque graphe partiel de l'ensemble d'arbres induit par un ensemble de types de pipettes P(b) pouvant mettre en place un composant b soit continu,
- s'il n'est pas possible de déterminer un tel ensemble d'arbres, on supprime des éléments de la liste d'affectation E jusqu'à ce qu'il soit possible de déterminer un tel ensemble d'arbres et
- dans lequel la solution à trouver est déterminée en solutionnant une série de problèmes de flux.

**19.** Dispositif selon l'une des revendications 16 à 18,
dans lequel le processeur est adapté de manière à ce que la série de problèmes de flux soit formée selon les règles suivantes :

$$\sum_{p:(b,p)\in E} x_{bp} = n_b \quad \forall\, b \in B$$

$$\sum_{p:(b,p)\in E} x_{bp} \le c_p \quad \forall\, p \in P,$$

avec

- $n_b$ indiquant un nombre de composants du type de composant b ∈ E à mettre en place,
- cp, p ∈ P, désignant une limite qui peut être définie par défaut et dont la variation permet de former la série de problèmes de flux,
- une première variable de solution $x_{bp}$ indiquant combien de composants du type de composant b ∈ B sont mis en place par une pipette du type de pipette p ∈ P.

**20.** Dispositif selon la revendication 14, dans lequel le processeur est adapté de manière à ce que,

- dans le cas où la suite acceptable n'existe pas, on vérifie s'il est possible de déterminer, pour des affectations possibles des types de composants aux types de pipettes selon la liste d'affectation, un ensemble d'arbres dont les noeuds seraient les types de pipettes, de manière à ce que chaque graphe partiel de l'ensemble d'arbres induit par un ensemble de types de pipettes P(b) pouvant mettre en place un composant b soit continu,
- s'il n'est pas possible de déterminer un tel ensemble d'arbres, la solution à trouver soit déterminée en solutionnant un programme linéaire, dans lequel les affectations possibles sont formulées.

**21.** Dispositif selon la revendication 14, dans lequel le processeur est adapté de manière à ce que le programme linéaire soit formé selon les règles suivantes :

$$\sum_{p:(b,p)\in E} x_{bp} = n_b \quad \forall\, b \in B$$

$$\sum_{p:(b,p)\in E} x_{bp} \le y_p \cdot z \quad \forall\, p \in P$$

$$\sum_{p\in P} y_p \le k,$$

avec

- $n_b$ indiquant un nombre de composants du type de composant b ∈ E à mettre en place,
- une première variable de solution $x_{bp}$ indiquant combien de composants du type de composant b ∈ E sont mis en place par une pipette du type de pipette p ∈ P,
- une seconde variable de solution yp indiquant combien de pipettes du type de pipette p ∈ P sont sélectionnées,

- k désignant un nombre de segments de la tête de mise en place,
- x, y ≥ 0 étant un nombre entier.

**22.** Dispositif selon la revendication 21, dans lequel le processeur est adapté de manière à ce que le programme linéaire soit solutionné en utilisant une méthode « branch-and-cut » (branchement et coupe).

**23.** Dispositif selon l'une des revendications 13 à 22, dans lequel le processeur est adapté de manière à ce que le procédé soit exécuté plusieurs fois à chaque fois pour un nombre de cycles différent.

**24.** Machine automatique de mise en place pourvue d'un dispositif selon l'une des revendications 13 à 23, comprenant un magasin de composants pour les composants, comprenant une tête de mise en place destinée à recevoir les pipettes, comprenant au moins une pipette pour recevoir les composants, comprenant un dispositif d'insertion pour planter les composants sur une carte imprimée.

FIG 1

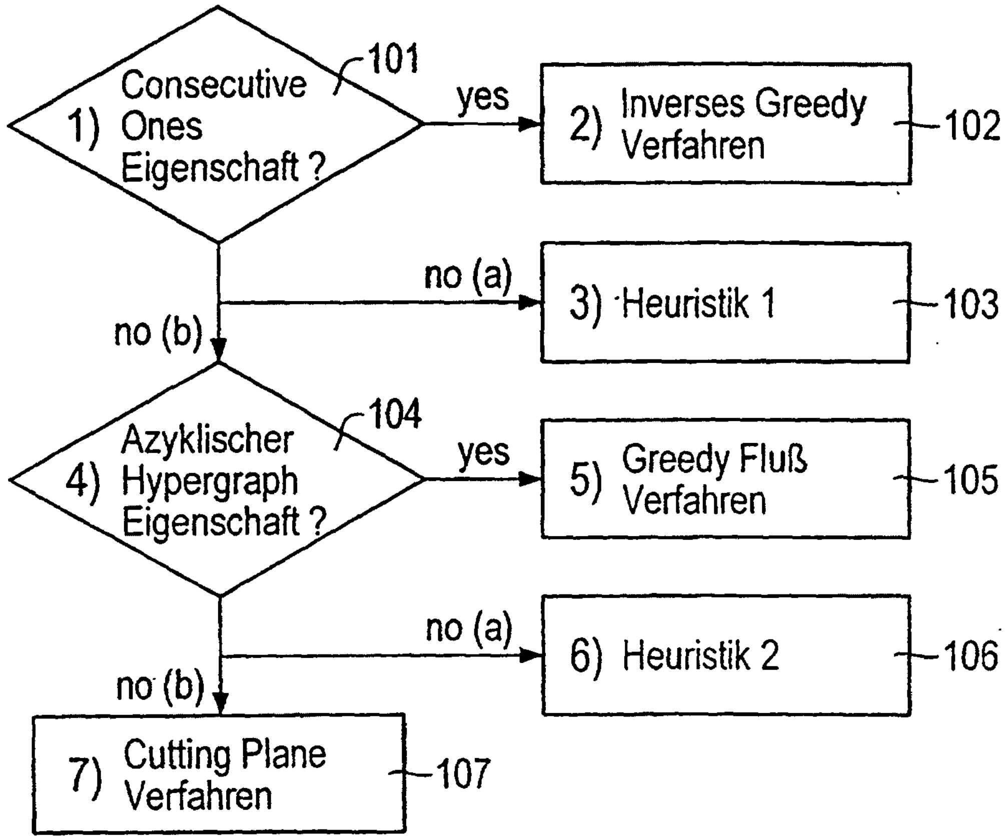
1) Consecutive Ones Eigenschaft ?
101
yes
2) Inverses Greedy Verfahren
102
no (a)
3) Heuristik 1
103
no (b)
4) Azyklischer Hypergraph Eigenschaft ?
104
yes
5) Greedy Fluß Verfahren
105
no (a)
6) Heuristik 2
106
no (b)
7) Cutting Plane Verfahren
107

FIG 2

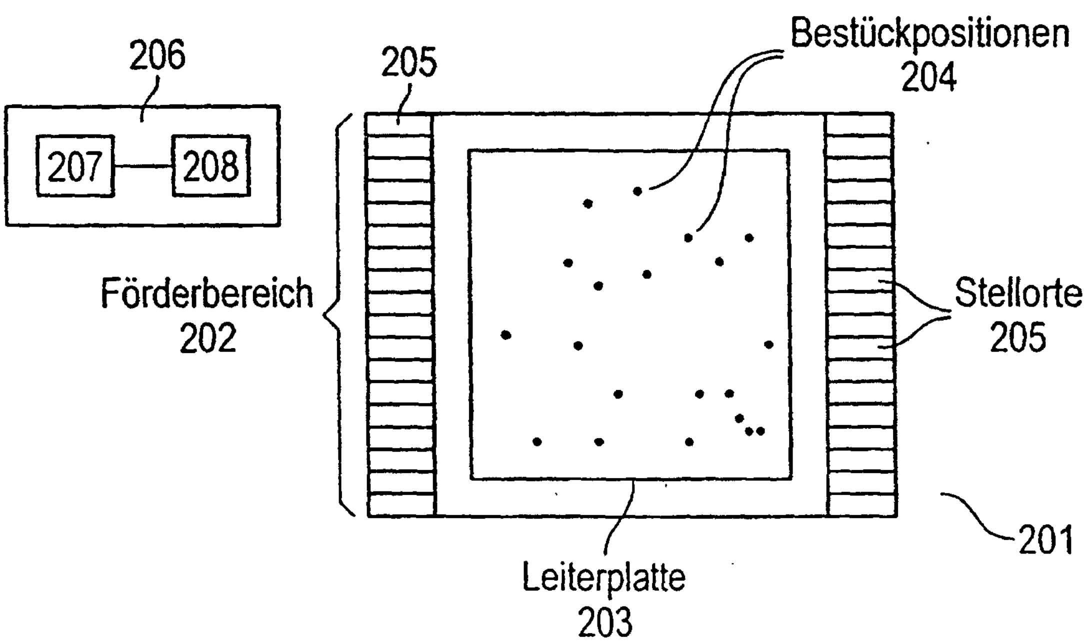
206
207
208
205
Bestückpositionen
204
Förderbereich
202
Stellorte
205
201
Leiterplatte
203

FIG 3A

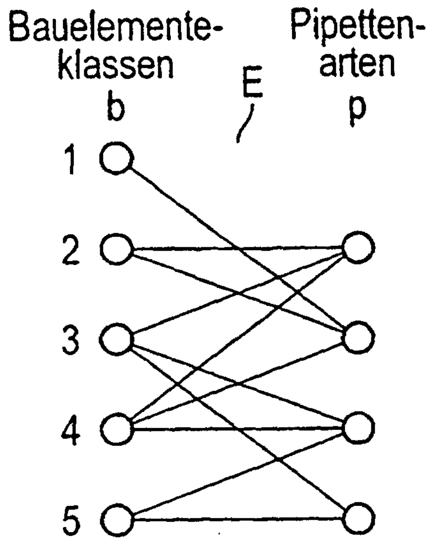


FIG 3B

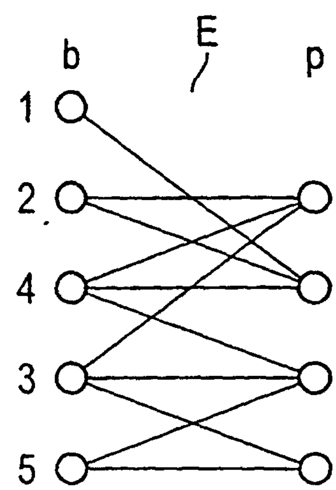


FIG 4A

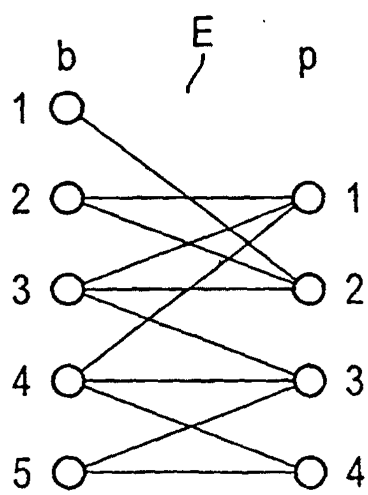


FIG 4B

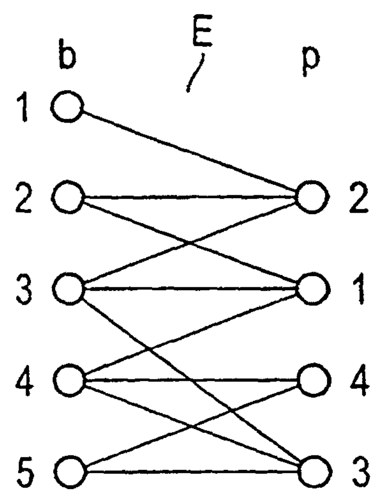

FIG 5A

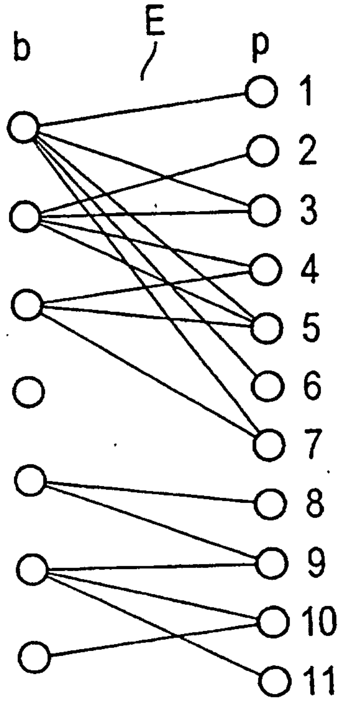


FIG 5B

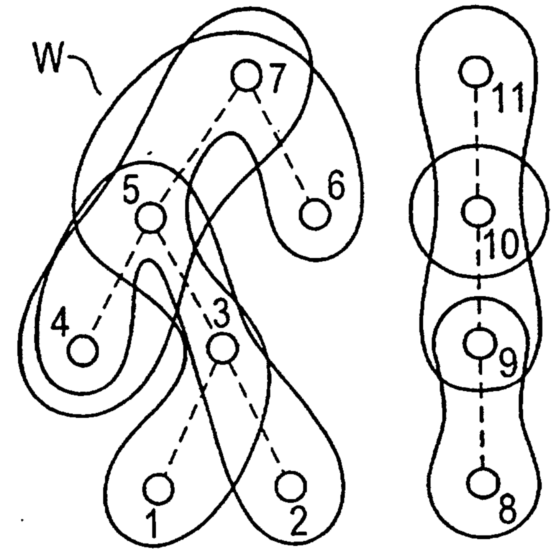


FIG 6